# EUROPÄISCHE PATENTSCHRIFT

(11) **EP 1 768 989 B1**
(45) Veröffentlichungstag und Bekanntmachung des Hinweises auf die Patenterteilung: **23.11.2011**
(21) Anmeldenummer: 05770990.9
(22) Anmeldetag: 14.07.2005
(51) Int. Cl.: C07F 15/00, H01L 51/30

(54) **METALLKOMPLEXE**
METAL COMPLEXES
COMPLEXES METALLIQUES

(30) Priorität: 16.07.2004 DE 102004034517
(43) Veröffentlichungstag der Anmeldung: 04.04.2007
(73) Patentinhaber: Merck Patent GmbH, 64293 Darmstadt (DE)
(72) Erfinder: STÖSSEL, Philipp, 60487 Frankfurt (DE); BREUNING, Esther, 65527 Niedernhausen (DE)
(86) Internationale Anmeldenummer: PCT/EP2005/007672
(87) Internationale Veröffentlichungsnummer: WO 2006/008069

(56) Entgegenhaltungen:
- EP-A- 0 321 353
- WO-A1-03/093283
- WO-A1-2005/113563
- US-B1- 6 753 156
- SLUGOVC C ET AL: "Generation of Heteroatom-Substituted Carbene Complexes of Iridium by Double C-H Activation of Ether and Amine Substrates" ANGEWANDTE CHEMIE. INTERNATIONAL EDITION, WILEY VCH VERLAG, WEINHEIM, DE, Bd. 39, Nr. 12, 2000, Seiten 2158-2160, XP002284927 ISSN: 1433-7851
- SLUGOVC C ET AL: "Investigation of the C-H Activation Potential of [Hydrotris(1H-pyrazolatokn1)borato(1-)]IRI DIUM(IRTPX) FRAGMENTS FEATURING AROMATIC SUBSTITUTENTS X AT THE 3-POSITION OF THE PYRAZOLE RINGS" HELVETICA CHIMICA ACTA, VERLAG HELVETICA CHIMICA ACTA. BASEL, CH, Bd. 84, 2001, Seiten 2868-2883, XP002284928 ISSN: 0018-019X
- PIGUET C ET AL: "Tridentate binding units as structural patterns for the design of nine-coordinate lanthanide building blocks with predetermined properties" JOURNAL OF ALLOYS AND COMPOUNDS, ELSEVIER SEQUOIA, LAUSANNE, CH, Bd. 303-304, Mai 2000 (2000-05), Seiten 94-103, XP004204340 ISSN: 0925-8388
- LEHN JEAN-MARIE REGNOUF DE VAINS J-B: "Synthesis of macrobicyclic cryptates incorporating bithiazole, bisimidazole and bipyrimidine binding subunits" TETRAHEDRON LETTERS, ELSEVIER, AMSTERDAM, NL, Bd. 30, Nr. 17, 1989, Seiten 2209-2212, XP002956338 ISSN: 0040-4039
- ALPHA ET AL: "Synthesis and Characterisation of the Sodium and Lithium Cryptates of Macrobicyclic Ligands Incorporating Pyridine, Bipyridine, and Biisoquinoline Units" HELVETICA CHIMICA ACTA, VERLAG HELVETICA CHIMICA ACTA. BASEL, CH, Bd. 71, 1988, Seiten 1042-1052, XP002165652 ISSN: 0018-019X
- REISFELD R ET AL: "Rare earth ions, their spectroscopy of cryptates and related complexes in sol-gel glasses" OPTICAL MATERIALS, ELSEVIER SCIENCE PUBLISHERS B.V. AMSTERDAM, NL, Bd. 24, Nr. 1-2, Oktober 2003 (2003-10), Seiten 1-13, XP004463609 ISSN: 0925-3467
- SEEL C ET AL: "MOLECULES WITH LARGE CAVITIES IN SUPRAMOLECULAR CHEMISTRY" ANGEWANDTE CHEMIE. INTERNATIONAL EDITION, WILEY VCH VERLAG, WEINHEIM, DE, Bd. 31, Nr. 5, 1. Mai 1992 (1992-05-01), Seiten 528-549, XP000255299 ISSN: 1433-7851

## Beschreibung

Metallorganische Verbindungen, speziell Verbindungen der d⁸-Metalle, werden in naher Zukunft in einer Reihe verschiedenartiger Anwendungen, die im weitesten Sinne der Elektronikindustrie zugerechnet werden können, Einsatz als funktionelle Materialien finden. Bei den auf organischen Komponenten basierenden organischen Elektrolumineszenzvorrichtungen bzw. den organischen lichtemittierenden Dioden (OLEDs) (z. B. US 4539507, US 5151629) ist die Markteinführung bereits erfolgt, wie die Autoradios der Firma Pioneer und die Mobiltelefone der Firmen Pioneer und SNMD mit "organischem Display" belegen. Weitere derartige Produkte stehen kurz vor der Einführung. Dennoch sind hier noch deutliche Verbesserungen nötig, um diese Displays zu einer echten Konkurrenz zu den derzeit marktbeherrschenden Flüssigkristallanzeigen zu machen.

Eine Entwicklung, die sich in den letzten Jahren abzeichnet, ist der Einsatz metallorganischer Komplexe, die Phosphoreszenz statt Fluoreszenz zeigen (M. A. Baldo et al., Appl. Phys. Lett. 1999, 75, 4-6). Aus theoretischen Spinstatistischen Gründen ist unter Verwendung metallorganischer Verbindungen als Phosphoreszenzemitter eine bis zu vierfache Energie- und Leistungseffizienz möglich. Ob sich diese Entwicklung durchsetzen wird, hängt davon ab, ob entsprechende Device-Kompositionen gefunden werden, die diese Vorteile (Triplett-Emission = Phosphoreszenz gegenüber Singulett-Emission = Fluoreszenz) auch in den OLEDs umsetzen können. Als wesentliche Bedingungen sind hier insbesondere eine hohe operative Lebensdauer und eine hohe thermische Stabilität, sowohl beim Betrieb, wie auch beim Aufdampfen, zu nennen. Dabei muss der effiziente chemische Zugang zu den entsprechenden Organometall-Verbindungen gegeben sein. Von besonderem Interesse ist dies, vor dem Hintergrund der Seltenheit dieser Metalle, bei Ruthenium-, Osmium-, Rhodium-, Iridium-, Platin- und GoldVerbindungen, um deren ressourcenschönende Nutzung zu ermöglichen.

Phosphoreszierende OLEDs zeigen bislang unter anderem folgende Schwachpunkte:
1. Die operative Lebensdauer ist allgemein noch deutlich zu gering, was der Einführung von phosphoreszierenden OLEDs in hochwertigen und langlebigen Vorrichtungen entgegensteht.
2. Viele der bekannten Metallkomplexe besitzen eine geringe thermische Stabilität, wie eigene Experimenten mit Metallkomplexen, die beispielsweise in WO 02/104080, in WO 02/44189 und in US 2003/0068526 beschrieben sind, gezeigt haben. Die mangelhafte thermische Stabilität führt bei Vakuumdeposition der Komplexe zwangsläufig zur Freisetzung organischer Pyrolyseprodukte, die zum Teil schon in geringen Mengen die operative Lebensdauer der OLEDs erheblich verringern. Insbesondere aber auch bei der Reinigung der Metallkomplexe durch Sublimation und beim Aufdampfen durch Vakuumverfahren wäre es wünschenswert, deutlich temperaturstabilere Komplexe zur Verfügung zu haben, da die Zersetzung zu großen Verlusten der Komplexe führt.
3. Insbesondere die Stabilität von Metallkomplexen, die außer Liganden vom Typ Phenylpyridin noch weitere Liganden enthalten, die keine Metall-Kohlenstoff-Bindung aufweisen (z. B. Acetylacetonat), ist bislang noch ungenügend, da diese Liganden im Allgemeinen zu labil an das zentrale Metallatom gebunden sind, wie eigene Experimente an derartigen Komplexen, wie sie z. B. in US 2004/0086742 beschrieben sind, gezeigt haben.

Besonders eine gleichzeitige Verbesserung der Lebensdauer und der thermischen Stabilität der Komplexe wäre vorteilhaft.

Es besteht daher ein Bedarf an alternativen Verbindungen, die die oben genannten Schwachpunkte nicht aufweisen, den bekannten Metallkomplexen jedoch in Bezug auf Effizienz und Emissionsfarbe mindestens gleichwertig sind.

Es wurde nun überraschend gefunden, dass Metallkomplexe polypodaler Liganden und Kryptate hervorragende Eigenschaften bei der Verwendung in OLEDs, insbesondere als Triplett-Emitter, aufzeigen.

Diese Verbindungen sind Gegenstand der vorliegenden Erfindung und zeichnen sich durch folgende Verbesserungen gegenüber dem Stand der Technik aus:
1. Die erfindungsgemäßen Verbindungen weisen - im Gegensatz zu vielen bekannten Metallkomplexen, die bei Sublimation der teilweisen oder vollständigen pyrolytischen Zersetzung unterliegen (z. B. gemäß WO 02/44189 und US 2003/0068526) - eine hohe thermische Stabilität auf. Diese Stabilität führt bei Verwendung in entsprechenden Vorrichtungen zu einer deutlichen Erhöhung der operativen Lebensdauer und ermöglicht weiterhin das unproblematische Aufbringen durch Vakuummethoden.
2. Die erfindungsgemäßen Verbindungen - eingesetzt als Elektrolumineszenzmaterial in reiner Form oder als Dotand in Kombination mit einem Matrixmaterial - führen in OLEDs zu hohen Effizienzen, wobei sich die Elektrolumineszenzvorrichtungen durch steile Strom-Spannungs-Kurven und besonders durch eine lange operative Lebensdauer auszeichnen.
3. Die erfindungsgemäßen Verbindungen weisen zum Teil eine exzellente Löslichkeit in organischen Lösungsmitteln auf. Damit lassen sich diese Materialien leichter reinigen und sind auch aus Lösung durch Beschichtungs- oder Drucktechniken verarbeitbar. Auch bei der üblichen Verarbeitung durch Verdampfen ist diese Eigenschaft von Vorteil, da so die Reinigung der Anlagen bzw. der eingesetzten Schattenmasken erheblich erleichtert wird.

Aus der WO 2003/093283 sind Metallkomplexe mit quadridentaten Liganden als Emitter für organische Elektrolumineszenzvorrichtungen bekannt.

Aus der WO 2005/113563 sind weiterhin Kryptate bekannt, in denen jeder Teilligand aus Cyclen oder Teilcyclen, die an das koordinieren, aufgebaut ist.

Die unten genauer ausgeführte Klasse der Metallkomplexe polypodaler Liganden und Kryptate und deren Verwendung als funktionelle Materialien in optoelektronischen Vorrichtungen ist neu; ihre effiziente Darstellung und Verfügbarkeit als Reinstoff ist hierfür aber von großer Bedeutung. Optoelektronische Bauteile enthaltend die unten genauer ausgeführte Klasse der Metallkomplexe polypodaler Liganden und Kryptate sind neu; die effiziente Darstellung und Verfügbarkeit dieser Metallkomplexe als Reinstoff ist für die Verwendung dieser Materialien in optoelektronischen Vorrichtungen von großer Bedeutung.

Gegenstand der vorliegenden Erfindung ist somit ein organisches elektronisches Bauteil ausgewählt aus der Gruppe bestehend aus organischen Leuchtdioden (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs) oder organischen Laserdioden (O-Laser), enthaltend einen oder mehrere Metallkomplexe gemäß Formel (1), 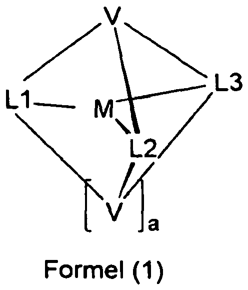 enthaltend mindestens ein Metall M, koordiniert an einen polypodalen Liganden L gemäß Formel (2), 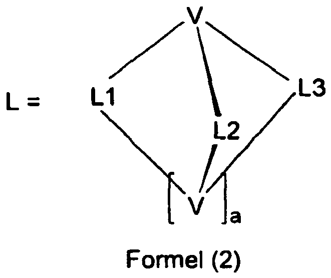 wobei V eine verbrückende Einheit ist, enthaltend 1 bis 80 Atome aus der dritten, vierten, fünften und/oder sechsten Hauptgruppe, die die drei Teilliganden L1, L2 und L3 kovalent miteinander verbindet, und wobei der Index a gleich 0 oder 1 ist, wobei im Fall a = 0 die verbrückende Einheit V entfällt;
dabei genügt der Teilligand L1 der Formel (3), 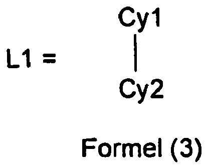 wobei Cy1 und Cy2 substituierte oder unsubstituierte cyclische Gruppen sind, die jeweils mindestens ein Donoratom oder ein C-Atom im Ring oder exocyclisch gebunden enthalten, über welches die cyclische Gruppe an das Metall gebunden ist; die Gruppen Cy1 und Cy2 sind über eine kovalente Bindung oder eine gemeinsame Kante miteinander verbunden und können zusätzlich über Substituenten miteinander verknüpft sein und so ein polycyclisches, aliphatisches oder aromatisches Ringsystem aufspannen;
der Teilligand L2 ist ein Donorligand, enthaltend ein oder mehrere Donoratome und 2 bis 40 C-Atome, mit der Maßgabe, dass der Teilligand L2 nicht aus zwei Cyclen oder Teilcyclen, die beide direkt oder über exocyclisch gebundene Donoratome an das Metall binden, aufgebaut ist;
der Teilligand L3 ist gleich oder verschieden dem Teilliganden L1 oder dem Teilliganden L2,
oder enthaltend ein oder mehrere konjugierte, teilkonjugierte und nicht-konjugierte Polymere oder Dendrimere enthaltend einen oder mehrere Komplexe gemäß Formel 1, wobei eine oder mehrere Bindungen der Komplexe zum Polymer oder Dendrimer vorhanden sind.

Unter einem Donoratom im Sinne dieser Erfindung wird eine Atom verstanden, das mindestens ein freies Elektronenpaar aufweist und das dadurch in der Lage ist, an eine Metallatom zu binden, wie beispielsweise O, S, N oder P. Unter einer Donorgruppe bzw. einem Donorliganden im Sinne dieser Erfindung wird eine chemische Gruppe verstanden, die mindestens ein derartiges Donoratom aufweist und dadurch an ein Metallatom binden kann.

Die Metallkomplexe gemäß Formel (1) können Komplexe polypodaler Liganden oder Kryptate sein, abhängig davon, ob eine verbrückende Einheit V (d. h. a = 0) oder zwei verbrückende Einheiten V (d. h. a = 1) anwesend sind. Unter einem Kryptat im Sinne dieser Erfindung wird eine Verbindung zwischen einem Kryptanden und einem Metallion verstanden, in der das Metallion von den Brücken des komplexbildenden Kryptanden dreidimensional umgeben ist. Unter einem Kryptanden im Sinne dieser Erfindung wird ein makropolycyclischer Ligand verstanden, insbesondere ein Ligand, in dem zwei Brückenkopfatome bzw. Brückenkopfgruppen durch drei Brücken verbunden sind, die jeweils in der Lage sind, an ein Metallatom zu koordinieren.

Die cyclischen Gruppen Cy1 und Cy2, die Homocyclen oder Heterocyclen sein können, können gesättigt, ungesättigt oder aromatisch sein. Bevorzugt sind die Gruppen aromatisch.

Die Cyclen Cy1 und Cy2 des Teilliganden L1 können über eine Einfachbindung miteinander verknüpft sein. Außerdem können die Homo- oder Heteroteilcyclen Cy1 und Cy2 über eine gemeinsame Kante verknüpft sein. Weiterhin können sie, neben der Verknüpfung über eine Einfachbindung oder eine gemeinsame Kante, über Substituenten an den Cyclen Cy1 und Cy2 bzw. den Teilcyclen miteinander verküpft sein und so ein polycyclisches, aromatisches oder aliphatisches Ringsystem aufspannen. Die prinzipiellen Verknüpfungsmöglichkeiten seien hier am Beispiel eines Benzolrings (Cy1) und eines Pyridinrings (Cy2) exemplarisch dargestellt, ohne die Vielfalt aller möglichen Verknüpfungen dadurch einschränken zu wollen:

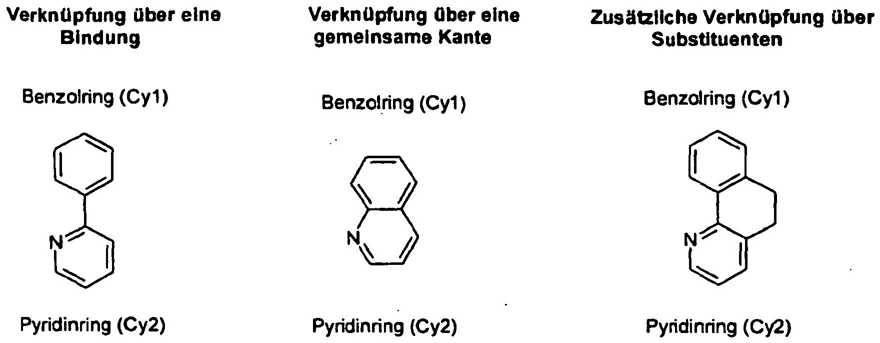

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung der Teilliganden L1, L2 und L3 und der verbrückenden Einheiten V so gewählt wird, dass sie die Ladung des komplexierten Metallions kompensieren.

Bevorzugt sind weiterhin Verbindungen gemäß Formel (1), dadurch gekennzeichnet, dass die Summe der Valenzelektronen um das Metallatom 18 beträgt. Diese Bevorzugung ist durch die besondere Stabilität dieser Metallkomplexe begründet (s. z. B. Elschenbroich, Salzer, Organometallchemie, Teubner Studienbücher, Stuttgart 1993).

Weiterhin bevorzugt sind Verbindungen gemäß Formel (1), dadurch gekennzeichnet, dass Cy1 ungleich Cy2 ist. Dabei bindet bevorzugt einer der beiden Cyclen über eine Metall-Kohlenstoff-Bindung und der andere über ein Donoratom ungleich Kohlenstoff.

Bevorzugt sind Verbindungen gemäß Formel (1), dadurch gekennzeichnet, dass die verbrückende Einheit V 1 bis 80 Atome aus der 3., 4., 5. und/oder 6. Hauptgruppe (Gruppe 13, 14, 15 oder 16 gemäß IUPAC) oder einen 3-bis 6-gliedrigen Homo- oder Heterocyclus aufweist. Diese bilden das Grundgerüst der verbrückenden Einheit. Dabei kann die verbrückende Einheit V auch unsymmetrisch aufgebaut sein, d. h. die Verknüpfung von V zu L1, L2 und L3 muss nicht identisch sein.

Die verbrückende Einheit V kann neutral, einfach negativ geladen oder einfach positiv geladen sein. Dabei wird die Ladung von V bevorzugt so gewählt, dass ein neutraler Komplex entsteht. So sind z. B. eine oder zwei neutrale verbrückende Einheiten V bevorzugt, wenn es sich um ein dreiwertiges Metallion M³⁺ und drei einfach negative Teilliganden L1, L2 und L3 handelt. Weiterhin ist eine einfach negative verbrückende Einheit V und gegebenenfalls eine weitere neutrale Einheit V bevorzugt, wenn es sich um ein vierwertiges Metallion M⁴⁺ und drei einfach negative Teilliganden L1, L2 und L3 handelt. Weiterhin sind zwei einfach negative verbrückende Einheiten V bevorzugt, wenn es sich um ein fünfwertiges Metallion M⁵⁺ und drei einfach negative Teilliganden L1, L2 und L3 handelt. Weiterhin ist eine einfach positive verbrückende Einheit V und gegebenenfalls eine weitere neutrale Einheit V bevorzugt, wenn es sich um ein zweiwertiges Metallion M²⁺ und drei einfach negative Teilliganden L1, L2 und L3 handelt. Weiterhin sind zwei einfach positive verbrückende Einheiten V bevorzugt, wenn es sich um ein einwertiges Metallion M⁺ und drei einfach negative Teilliganden L1, L2 und L3 handelt.

Bevorzugt sind weiterhin Verbindungen gemäß Formel (1), dadurch gekennzeichnet, dass der Teilligand L2, der ein oder mehrere Donoratome enthält, ein zweizähnig chelatisierender Teilligand mit zwei Donoratomen ist.

Nochmals weiterhin bevorzugt sind Verbindungen gemäß Formel (1), dadurch gekennzeichnet, dass der Ligand L gemäß Formel (4) zwei Teilliganden vom Typ L1 und einen zweizähnig chelatisierenden Teilliganden vom Typ L2 aufweist:

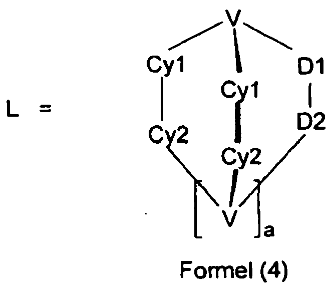

Dabei stehen die Symbole D1 und D2, jeweils gleich oder verschieden, für Donorgruppen, enthaltend jeweils ein Donoratom; die weiteren verwendeten Symbole und Indizes haben die oben genannten Bedeutungen.

Besonders bevorzugt sind Verbindungen gemäß Formel (1), dadurch gekennzeichnet, dass L3 = L1 ist.

Bevorzugte polypodale Metallkomplexe sind ausgewählt aus der Gruppe der Komplexe enthaltend Teilstrukturen gemäß Formel (5) bis (16), die im Folgenden näher erläutert werden.

Bevorzugt sind Metallkomplexe gemäß Formel (1), deren Teilligand L1 zusammen mit dem Metall M und der verbrückenden Einheit V eine Teilstruktur gemäß den Formeln (5) bis (16) aufweist: 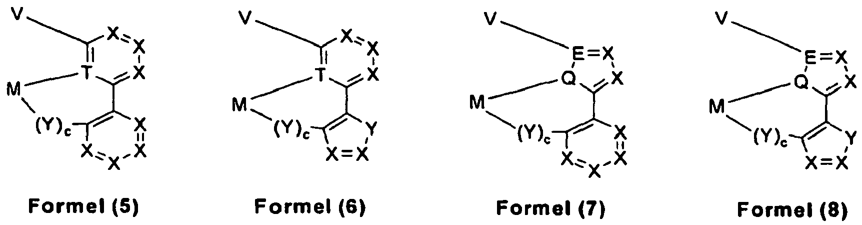 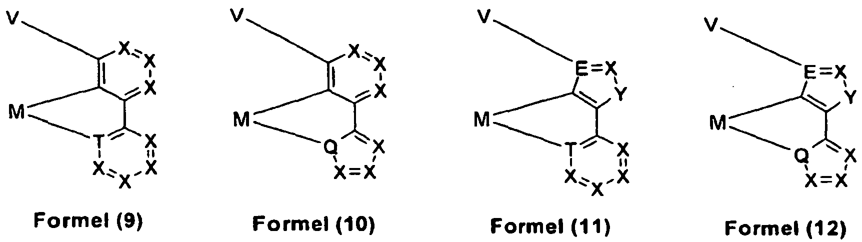 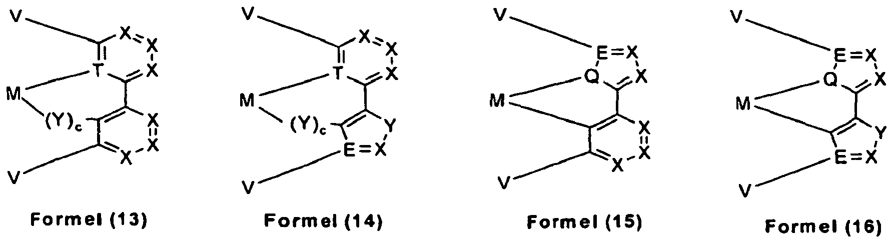 wobei die Symbole und Indizes folgende Bedeutung haben:
- M: ist gleich oder verschieden bei jedem Auftreten ein Übergangsmetall;
- E: ist gleich oder verschieden bei jedem Auftreten C, N oder P;
- Q: ist gleich oder verschieden bei jedem Auftreten O, S, Se, Te oder N;
- T: ist gleich oder verschieden bei jedem Auftreten N, P oder C;
- X: ist gleich oder verschieden bei jedem Auftreten CR, N oder P;
- Y: ist gleich oder verschieden bei jedem Auftreten NR¹, O, S, Se, Te, SO, SeO, TeO, SO₂, SeO₂, TeO₂, R¹SO, R¹SeO, R¹TeO, R¹SO₂, R¹SeO₂, R¹TeO₂, R¹PO oder (R¹)₂PO;
- V: ist gleich oder verschieden bei jedem Auftreten B, BR⁻, B(CR₂)₃, RB(CR₂)3⁻, B(O)₃, RB(O)₃⁻, B(CR₂CR₂)₃, RB(CR₂CR₂)₃⁻, B(CR₂O)₃, RB(CR₂O)₃⁻, B(OCR₂)₃, RB(OCR₂)₃⁻, Al(O)₃, RAl(O)₃⁻, Al(OCR₂)₃, RAl(OCR₂)₃⁻, CR; CO⁻, CN(R¹)₂, RC(CR₂)₃, RC(O)₃, RC(CR₂CR₂)₃, RC(CR₂O)₃, RC(OCR₂)₃, RC(SiR₂)₃, RC(SiR₂CR₂)₃, RC(CR₂SiR₂)₃, RC(SiR₂SiR₂)₃, SiR, RSi(CR₂)₃, RSi(O)₃, RSi(CR₂CR₂)₃, RSi(OCR₂)₃, RSi(CR₂O)₃, RSi(SiR₂)₃, RSi(SiR₂CR₂)₃, RSi(CR₂SiR₂)₃, RSi(SiR₂SiR₂)₃, N, NO, NR⁻, N(CR₂)₃, RN(CR₂)₃⁺, N(C=O)₃, N(CR₂CR₂)₃, RN(CR₂CR₂)⁺, P, PO, PS, PSe, PTe, P(O)₃, PO(O)₃, P(OCR₂)₃, PO(OCR₂)₃, P(CR₂)₃, PO(CR₂)₃, P(CR₂CR₂)₃, PO(CR₂CR₂)₃, As, AsO, AsS, AsSe, AsTe, As(O)₃, AsO(O)₃, As(OCR₂)₃, AsO(OCR₂)₃, As(CR₂)₃, AsO(CR₂)₃, As(CR₂CR₂)₃, AsO(CR₂CR₂)₃, Sb, SbO, SbS, SbSe, SbTe, Sb(O)₃, SbO(O)₃, Sb(OCR₂)₃, SbO(OCR₂)₃, Sb(CR₂)₃, SbO(CR₂)₃, Sb(CR₂CR₂)₃, SbO(CR₂CR₂)₃, Bi, BiO, BiS, BiSe, BiTe, Bi(O)₃, BiO(O)₃, Bi(OCR₂)₃, BiO(OCR₂)₃, Bi(CR₂)₃, BiO(CR₂)₃, Bi(CR₂CR₂)₃, BiO(CR₂CR₂)₃, S⁺, S(CR₂)₃⁺, S(CR₂CR₂)₃⁺, Se⁺, Se(CR₂)₃⁺, Se(CR₂CR₂)₃⁺, Te⁺, Te(CR₂)₃⁺, Te(CR₂CR₂)₃⁺ oder entsprechende unsymmetrische Analoga; oder eine Einheit gemäß Formel (17) oder Formel (18), 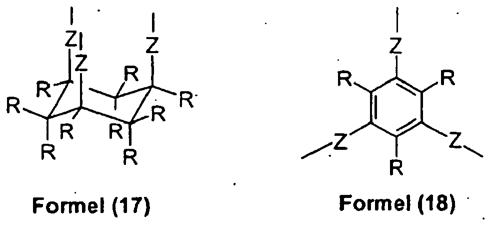
- Z: ist bei jedem Auftreten gleich oder verschieden eine bivalente Gruppe CR₂, NR, O, S, SiR₂, PR, CR₂-CR₂, CR₂-NR, CR₂-O, CR₂-S, CR₂-SiR₂ oder CR₂-PR;
- R: ist gleich oder verschieden bei jedem Auftreten H, F, Cl, Br, I, NO₂, CN, eine geradkettige, verzweigte oder cyclische Alkyl- oder Alkoxygruppe mit 1 bis 20 C-Atomen, wobei eine oder mehrere nicht benachbarte CH₂-Gruppen durch -R¹C=CR¹-, -C≡C-, Si(R¹)₂, Ge(R¹)₂, Sn(R¹)₂, C=O, C=S, C=Se, C=NR¹, -O-, -S-, -NR¹- oder -CONR¹- ersetzt sein können und wobei ein oder mehrere H-Atome durch F ersetzt sein können, oder eine Aryl-, Aryloxy- oder Heteroarylgruppe mit 1 bis 14 C-Atomen, die durch einen oder mehrere nicht aromatische Reste R substituiert sein kann, oder eine Diarylaminogruppe mit 6 bis 20 C-Atomen, die durch einen oder mehrere nicht aromatische Reste R substituiert sein kann; dabei können mehrere Substituenten R, sowohl am selben Ring als auch an den beiden unterschiedlichen Ringen zusammen wiederum ein weiteres mono- oder polycyclisches, aliphatisches, aromatisches und/oder benzoannelliertes Ringsystem aufspannen;
- R¹: ist gleich oder verschieden bei jedem Auftreten H oder ein aliphatischer oder aromatischer Kohlenwasserstoffrest mit 1 bis 20 C-Atomen;
- c: ist gleich oder verschieden bei jedem Auftreten 0 oder 1.

Die Teilstrukturen gemäß den Formeln (5) bis (16), ohne das Metall M und ohne die verbrückende(n) Einheit(en) V betrachtet, entsprechen dabei dem Teilliganden L1.

Bevorzugt sind Verbindungen, in denen M bei jedem Auftreten gleich oder verschieden für ein Übergangsmetallion mit der Ordnungszahl größer 38 steht, besonders bevorzugt für Wolfram, Rhenium, Ruthenium, Osmium, Rhodium, Iridium, Platin oder Gold.

Bevorzugt sind weiterhin Verbindungen, in denen Q bei jedem Auftreten gleich oder verschieden für O, S oder N steht, besonders bevorzugt für O oder S.

Bevorzugt sind weiterhin Verbindungen, in denen E bei jedem Auftreten gleich oder verschieden für C oder N steht, besonders bevorzugt für C.

Bevorzugt sind weiterhin Verbindungen, in denen T bei jedem Auftreten gleich oder verschieden für N oder P steht, besonders bevorzugt für N.

Bevorzugt sind weiterhin Verbindungen, in denen X bei jedem Auftreten gleich oder verschieden für CR oder N steht.

Bevorzugt sind weiterhin Verbindungen, in denen Y bei jedem Auftreten gleich oder verschieden für O, S oder NR¹ steht.

Bevorzugt sind weiterhin Verbindungen, in denen V bei jedem Auftreten gleich oder verschieden für B, BR⁻, B(CR₂)₃, RB(CR₂)₃⁻, B(O)₃, RB(O)₃⁻, B(CR₂CR₂)₃, B(OCR₂)₃, RB(OCR₂)₃⁻, CR, CNR¹₂, RC(CR₂)₃, RC(O)₃, RC(CR₂CR₂)₃, RC(CR₂O)₃, RC(OCR₂)₃, SiR, RSi(CR₂)₃, RSi(O)₃, RSi(CR₂CR₂)₃, RSi(OCR₂)₃, RSi(CR₂O)₃, N, NR⁺, N(CR₂)₃, RN(CR₂)₃⁺, N(C=O)₃, N(CR₂CR₂)₃, RN(CR₂CR₂)⁺, P, PO, P(O)₃, PO(O)₃, P(OCR₂)₃, PO(OCR₂)₃, S⁺, S(CR₂)₃⁺, S(CR₂CR₂)₃⁺ oder entsprechende unsymmetrische Analoga oder eine Gruppe gemäß Formel (17) oder Formel (18) steht. Besonders bevorzugt steht V bei jedem Auftreten gleich oder verschieden für B(O)₃, RB(O)₃⁻, B(OCR₂)₃, RB(OCR₂)₃⁻, RC(CR₂CR₂)₃, RC(CR₂O)₃, P(O)₃, P(OCR₂)₃, RC(CR₂)₃, RSi(O)₃, N(CR₂)₃, RN(CR₂)₃⁺, N(CR₂CR₂)₃ oder entsprechende unsymmtrische Analoga oder eine Gruppe gemäß Formel (17) oder Formel (18).

Bevorzugt sind weiterhin Verbindungen, in denen Z bei jedem Auftreten gleich oder verschieden für eine bivalente Gruppe CR₂, NR, O, S, SiR₂ oder PR steht, besonders bevorzugt für eine bivalente Gruppe CR₂, NR oder O.

Bevorzugt sind weiterhin Verbindungen, in denen R bei jedem Auftreten gleich oder verschieden für H, F, Cl, Br, I, CN, eine geradkettige, verzweigte oder cyclische Alkyl- oder Alkoxygruppe mit 1 bis 6 C-Atomen oder eine Aryl-, Aryloxy- oder Heteroarylgruppe mit 3 bis 8 C-Atomen, die durch einen oder mehrere nichtaromatische Reste R substituiert sein kann, oder eine Diarylaminogruppe mit 8 bis 12 C-Atomen, die durch einen oder mehrere nicht aromatische Reste R substituiert sein kann, steht; dabei können zwei oder mehrere Substituenten R, sowohl am selben Ring als auch an den beiden unterschiedlichen Ringen zusammen wiederum ein weiteres mono- oder polycyclisches, aliphatisches, aromatisches und/oder benzoannelliertes Ringsystem aufspannen.

Bevorzugt sind weiterhin Verbindungen, in denen der Index c = 0 ist.

Die Metalle können dabei in verschiedenen Wertigkeiten vorliegen. Bevorzugt sind dabei die oben genannten Metalle in den Wertigkeiten W(II), W(III), W(IV), Re(II), Re(III), Re(IV), Ru(II), Ru(III), Os(II), Os(III), Rh(III), Ir(III), Ir(IV), Pt(IV) und Au(III).

Beim Teilliganden L2 handelt es sich bevorzugt um zweizähnig chelatisierende Liganden, die zwei Donorgruppen D1 und D2 aufweisen, wobei die entsprechenden Donoratome bevorzugt ausgewählt sind aus der 5. und 6. Hauptgruppe oder Isonitrilgruppen darstellen; dabei dürfen die Donorgruppen D1 und D2 nicht beide cyclische Systeme darstellen, die beide an das Metall binden. Weiterhin bevorzugt weist der komplexierte Teilligand L2 keine direkte Metall-Kohlenstoff-Bindung auf. Dem Fachmann sind eine große Vielfalt geeigneter zweizähniger Liganden bekannt, und viele Beispiele werden in Cotton, Wilkinson, Anorganische Chemie, 2. Auflage, Verlag Chemie, Weinheim; 1970, S. 917-972 aufgeführt.

Besonders bevorzugte Donoratome der Donorgruppen D1 und D2 sind Stickstoff, Phosphor, Sauerstoff und Schwefel.

Bevorzugte Stickstoff-haltige Donorgruppen sind aromatische Stickstoffheterocyclen, beispielsweise Pyridin, Chinolin, Isochinolin, Pyrazin, Chinoxalin, Pyrimidin, Pyridazin, Triazin, Pyrrol, Indol, Imidazol, Benzimidazol, Pyrazol oder Triazol, aliphatische Amine, aliphatische cyclische Amine, beispielsweise Pyrrolidin, Piperidin oder Morpholin, Nitrile, Amide, Imide und Imine, die jeweils mit Gruppen R substituiert oder unsubstituiert sein können.

Bevorzugte Phosphor-haltige Donorgruppen sind Alkyl-, Aryl- oder gemischte Alkylarylphosphine, Alkylhalogen-, Arylhalogen- oder gemischte Alkylarylhalogenphosphine, Alkyl-, Aryl- oder gemischte Alkylarylphosphite oder Phosphaaromaten, wie beispielsweise Phosphabenzol, die jeweils mit Gruppen R substituiert oder unsubstituiert sein können.

Bevorzugte Sauerstoff-haltige Donorgruppen sind Alkohole, Alkoholate, offenkettige oder cyclische Ether, Carbonylgruppen, Phosphinoxidgruppen, Sulfoxidgruppen, Carboxylate, Phenole, Phenolate, Oxime, Hydroxamate, β-Ketoketonate, β-Ketoester und β-Diester, die jeweils mit Gruppen R substituiert oder unsubstituiert sein können, wobei die letztgenannten Gruppen zweizähnig chelatisierende Liganden darstellen.

Bevorzugte Schwefel-haltige Donorgruppen sind aliphatische oder aromatische Thiole und Thiolate, offenkettige oder cyclische Thioether, Thiophen, Thiocarbonylgruppen, Phosphinsulfide und Thiocarboxylate, die jeweils mit Gruppen R substituiert oder unsubstituiert sein können.

Aus diesen Donorgruppen lassen sich die bevorzugten zweizähnig chelatisierenden Teilliganden L2 bilden, indem zwei dieser Gruppen, die gleich oder verschieden sein können und die gleiche oder unterschiedliche Donoratome aufweisen können, jedoch keine zwei cyclischen koordinierenden Systeme darstellen dürfen, kombiniert werden. Die so gebildeten Teilliganden L2 sind kovalent mit der verknüpfenden Einheit V verbunden und können auch durch einen oder mehrere Reste R substituiert sein.

Beispiele für derartige Teilliganden L2 sind substituierte oder unsubstituierte β-Ketoketonate, β-Ketoester, β-Diester, Carboxylate abgeleitet von Aminocarbonsäuren, wie z. B. Pyridin-2-carbonsäure, Chinolin-2-carbonsäure, Glycin, Dimethylglycin, Alanin oder Dimethylaminoalanin, Iminoacetoacetonate, Hydroxamate, Pyridylphosphine, α-Phosphinocarboxylate, Glycolether, Etheralkoholate, Dialkoholate abgeleitet von Dialkoholen, wie z. B. Ethylenglykol oder 1,3-Propylenglykol, Dithiolate abgeleitet von Dithiolen, wie z. B. 1,2-Ethylendithiol oder 1,3-Propylendithiol, Diamine, wie z. B. Ethylendiamin, Propylendiamin oder cis- oder trans-Diaminocyclohexan, Imine, wie z. B. 2[(1-(Phenylimino)ethyl]pyridin, 2[(1-(2-Methylphenylimino)ethyl]pyridin, 2[(1-(2,6-Di-*iso-*propylphenylimino)ethyl]pyridin, 2[(1-(Methylimino)ethyl]pyridin, 2[(1-(ethylimino)ethyl]pyridin, 2[(1-(*Iso*-Propylimino)ethyl]pyridin oder 2[(1-(*Tert-*Butylimino)ethyl]pyridin, Diimine, wie z. B. 1,2-Bis(methylimino)ethan, 1,2-Bis(ethylimino)ethan, 1,2-Bis(*iso*-propylimino)ethan, 1,2-Bis(*tert*-butylimino)ethan, 2,3-Bis(methylimino)butan, 2,3-Bis(ethylimino)butan, 2,3-Bis(*iso*-propylimino)butan, 2,3-Bis(*tert*-butylimino)butan, 1,2-Bis(phenylimino)ethan, 1,2-Bis(2-methylphenylimino)ethan, 1,2-Bis(2,6-di-*iso*-propylphenylimino)ethan, 1,2-Bis(2,6-di-*tert*-butylphenylimino)ethan, 2,3-Bis(phenylimino)butan, 2,3-Bis(2-methylphenylimino)butan, 2,3-Bis(2,6-di-iso-propylphenylimino)butan oder 2,3-Bis(2,6-di-*tert*-butylphenylimino)butan, Diphosphine, wie z. B. Bisdiphenylphosphinomethan, Bis-diphenylphosphinoethan, Bis(diphenylphosphino)propan, Bis(dimethylphosphino)methan, Bis(dimethylphosphino)ethan, Bis(dimethylphosphino)propan, Bis(diethylphosphino)methan, Bis(diethylphosphino)ethan, Bis(diethylphosphino)propan, Bis(di-*tert*-butylphosphino)methan, Bis(di-*tert-*butylphosphino)ethan, Bis(*tert*-butylphosphino)propan, Salicyliminate abgeleitet von Salicyliminen, wie z. B. Methylsalicylimin, Ethylsalicylimin oder Phenylsalicylimin, etc. Dem Fachmann ist es jedoch ein Leichtes, ohne weiteres erfinderisches Zutun aus den aufgeführten Donorgruppen weitere Teilliganden L2 zu bilden und diese in den Liganden L und den entsprechenden Metallkomplexen gemäß Formel (1) einzusetzen.

Ein weiterer Gegenstand der vorliegenden Erfindung sind Metallkomplexe gemäß Formel (1), 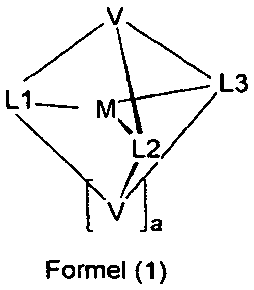 enthaltend mindestens ein Metall M, koordiniert an einen polypodalen Liganden L gemäß Formel (2), 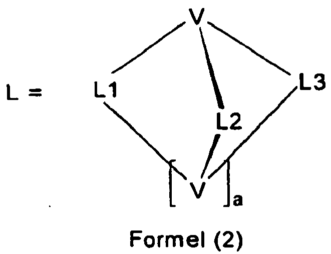 wobei V eine verbrückende Einheit ist, enthaltend 1 bis 80 Atome aus der dritten, vierten, fünften und/oder sechsten Hauptgruppe, die die drei Teilliganden L1, L2 und L3 kovalent miteinander verbindet, und wobei der Index a gleich 0 oder 1 ist, wobei im Fall a = 0 die verbrückende Einheit V entfällt;
dabei genügt der Teilligand L1 der Formel (3), 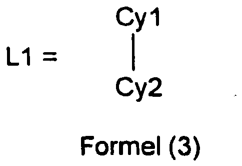 wobei Cy1 und Cy2 substituierte oder unsubstituierte cyclische Gruppen sind, die jeweils mindestens ein Donoratom oder ein C-Atom im Ring oder exocyclisch gebunden enthalten, über welches die cyclische Gruppe an das Metall gebunden ist; die Gruppen Cy1 und Cy2 sind über eine kovalente Bindung oder eine gemeinsame Kante miteinander verbunden und können zusätzlich über Substituenten miteinander verknüpft sein und so ein polycyclisches, aliphatisches oder aromatisches Ringsystem aufspannen;
der Teilligand L2 ist ein Donorligand, enthaltend ein oder mehrere Donoratome und 2 bis 40 C-Atome, mit der Maßgabe, dass der Teilligand L2 nicht aus zwei Cyclen oder Teilcyclen, die beide an das Metall binden, aufgebaut ist;
der Teilligand L3 ist gleich oder verschieden dem Teilliganden L1 oder dem Teilliganden L2,
dadurch gekennzeichnet, dass der Teilligand L2 ein zweizähnig chelatisierender Ligand mit zwei Donoratomen ist, und dass weiterhin entweder der Index a = 0 ist oder dass Cy1 ungleich Cy2 ist und einer der beiden Cyclen über eine Metall-Kohlenstoff-Bindung und der andere über ein Donoratom ungleich Kohlenstoff an das Metall bindet.

Dabei ist es bevorzugt, dass der Ligand L eine Struktur gemäß Formel (4) aufweist: 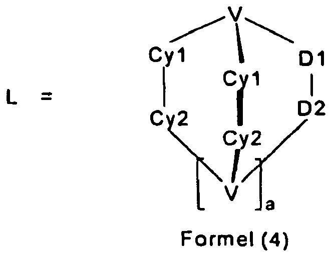 wobei die Symbole D1 und D2, jeweils gleich oder verschieden, für Donorgruppen, enthaltend jeweils ein Donoratom, stehen; die weiteren verwendeten Symbole und Indizes haben die oben genannten Bedeutungen.

Für die weiteren Ausführungsformen der Komplexe gelten die oben bei den organischen elektronischen Bauteilen genannten Bevorzugungen.

Die erfindungsgemäßen Komplexe gemäß Formel (1) sind prinzipiell durch verschiedene Verfahren herstellbar, wobei sich jedoch die im Folgenden beschriebenen Verfahren als besonders gut geeignet herausgestellt haben.

Daher ist ein weiterer Gegenstand der vorliegenden Erfindung ein Verfahren zur Herstellung der Komplexe gemäß Formel (1) durch Umsetzung der Liganden gemäß Formel (2) bzw. Vorstufen dieser Liganden mit Metallalkoholaten gemäß Formel (19), mit Metallketoketonaten gemäß Formel (20) oder Metallhalogeniden gemäß Formel (21), 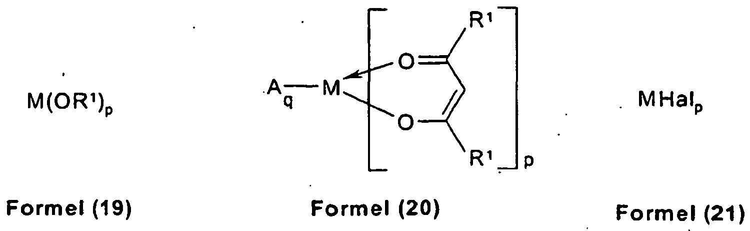 wobei für die Symbole und Indizes gilt:
- M: ist bei jedem Auftreten gleich oder verschieden ein Übergangsmetallion;
- Hal: ist bei jedem Auftreten gleich oder verschieden F, Cl, Br oder I;
- A: ist bei jedem Auftreten gleich oder verschieden ein neutraler oder monoanionischer, einzähniger oder zweizähniger Ligand, beispielsweise ein Halogenid oder Hydroxid;
- p: ist bei jedem Auftreten gleich oder verschieden 1, 2, 3, 4 oder 5, wobei p in Formel (19) und (21) die Wertigkeit des Metalls M angibt;
- q: ist bei jedem Auftreten gleich oder verschieden 0, 1, 2, 3 oder 4, bevorzugt 0, 1 oder 2;
dabei kann die Verbindung gemäß Formel (20) auch geladen sein und noch ein Gegenion enthalten; die weiteren Symbole haben dieselbe Bedeutung, wie oben angegeben.

Die Synthese kann beispielsweise thermisch, photochemisch oder durch Mikrowellenstrahlung aktiviert werden. Die Synthese tris-ortho-metallierter Metallkomplexe ist allgemein in WO 02/060910, WO 04/085449 und WO 04/108738 beschrieben.

In einem bevorzugten Syntheseverfahren wird der Ligand gemäß Formel (2) mit Metallverbindungen, wie durch Formeln (19), (20) und (21) beschrieben, umgesetzt. Diese Synthesemethode ist in Schema 1 dargestellt:

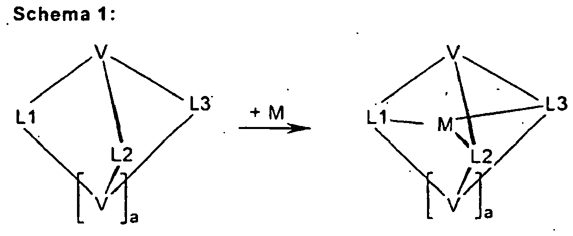

Als weiteres bevorzugtes Syntheseverfahren der erfindungsgemäßen Komplexe und Kryptate hat sich die Templatsynthese erwiesen, wie in Schema 2 dargestellt. Dazu werden Metallverbindungen, wie durch die Formeln (19), (20) und (21) beschrieben, mit einer einfachen, makrocyclischen oder polypodalen Vorstufe des Liganden umgesetzt, wobei sich die Ligandenvorstufe vom Liganden dadurch unterscheidet, dass sie keine oder nur eine statt eine oder zwei verbrückenden Einheiten V enthält oder dass sie nur zwei der drei Teilliganden L1, L2 und L3 enthält. In einem zweiten Syntheseschritt wird dann in einer komplexanalogen Reaktion, also einer Reaktion am Metallkomplex, die verbrückende Einheit V eingeführt, bzw. es werden beide verbrückenden Einheiten V eingeführt, bzw. es wird der dritte Teilligand L1 bzw. L2 bzw. L3 eingeführt und mit den verbrückenden Einheiten V verknüpft. Diese Synthesemethoden haben den Vorteil, dass durch die bereits erfolgte Komplexbildung die drei Teilliganden L1, L2 und L3 in einer räumlich bevorzugten Anordnung vorliegen, die einen einfachen Ringschluss zur Einführung von V bzw. zur Verknüpfung des dritten Teilliganden ermöglicht, was unter Verwendung der nicht komplexierten Teilliganden nur unter größerem technischen Aufwand und in schlechteren Ausbeuten möglich ist. Diese Synthesemethoden sind in Schema 2 dargestellt:

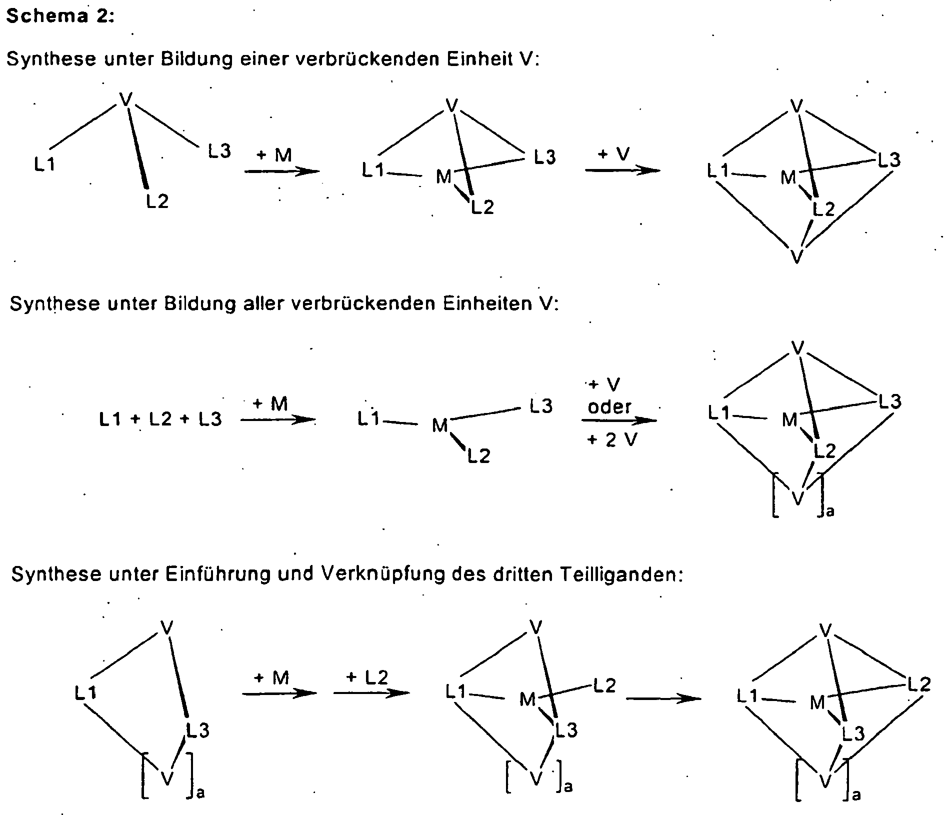

Durch diese Verfahren lassen sich die Komplexe leicht in hoher Reinheit, bevorzugt in einer Reinheit von > 99% nach ¹H-NMR oder HPLC, erhalten.

Mit den hier erläuterten Synthesemethoden lassen sich unter anderem die im Folgenden dargestellten Beispiele für Komplexe gemäß Formel (1) herstellen.

| | | |
|---|---|---|
| 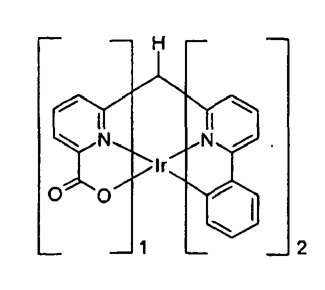 | 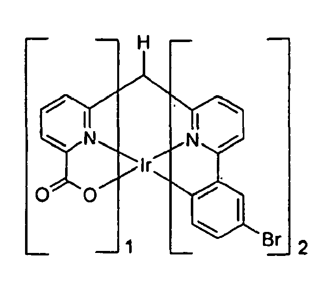 | 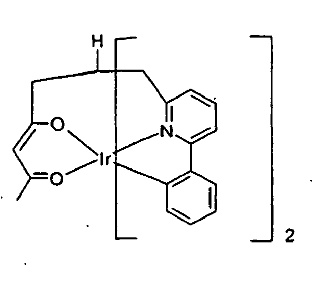 |
| Beispiel 1 | Beispiel 2 | Beispiel 3 |
| 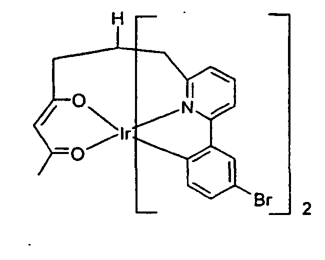 | 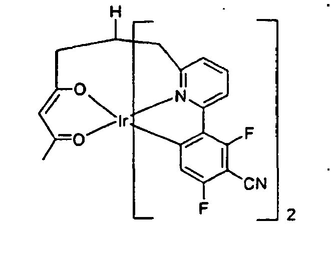 | 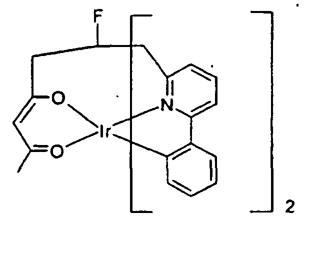 |
| Beispiel 4 | Beispiel 5 | Beispiel 6 |
| 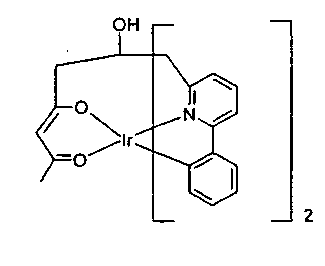 | 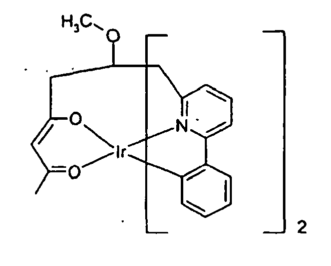 | 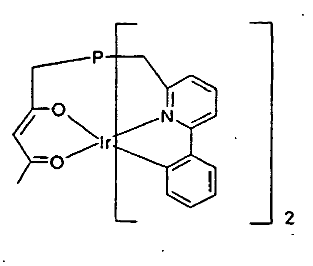 |
| Beispiel 7 | Beispiel 8 | Beispiel 9 |
| 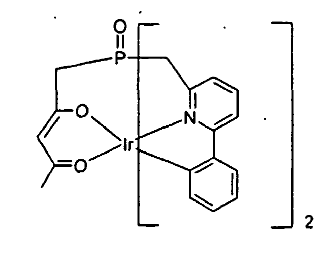 | 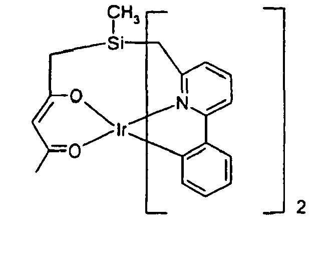 | 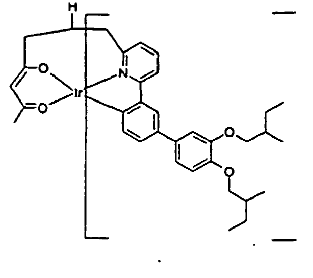 |
| Beispiel 10 | Beispiel 11 | Beispiel 12 |
| 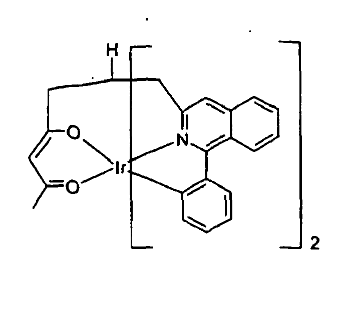 | 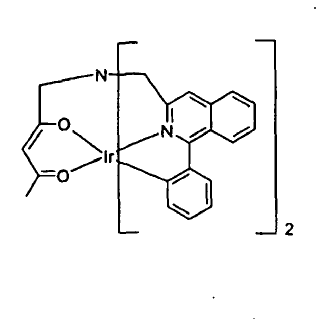 | 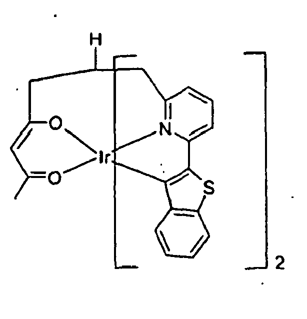 |
| Beispiel 13 | Beispiel 14 | Beispiel 15 |
| 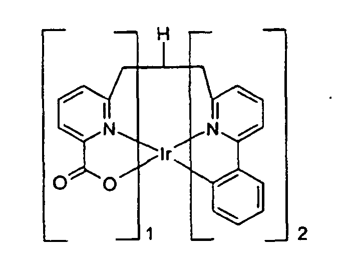 | 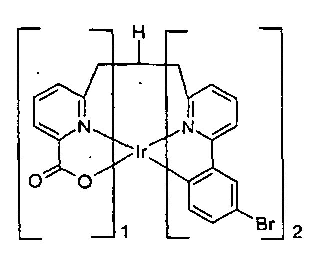 | 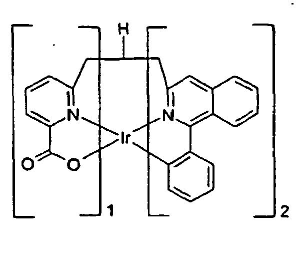 |
| Beispiel 16 | Beispiel 17 | Beispiel 18 |
| 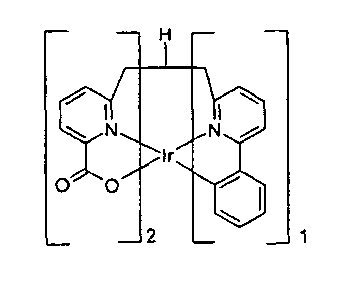 | 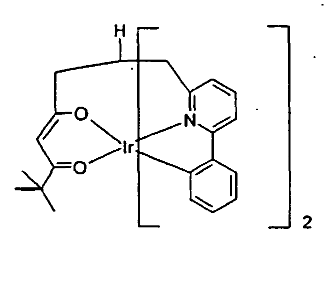 | 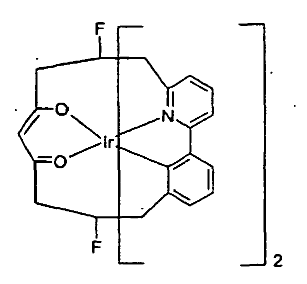 |
| Beispiel 19 | Beispiel 20 | Beispiel 21 |
| 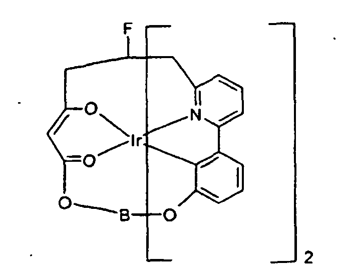 | 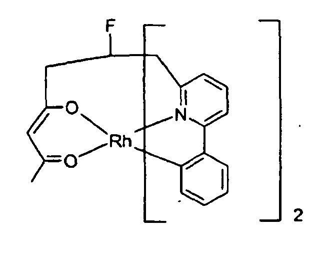 | 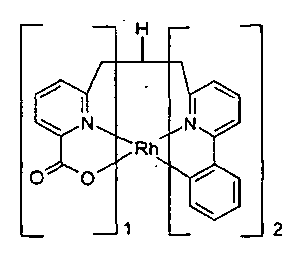 |
| Beispiel 22 | Beispiel 23 | Beispiel 24 |
| 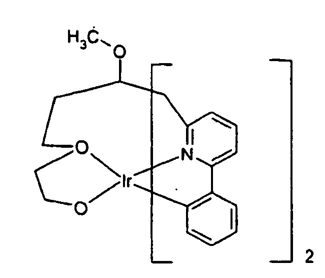 | 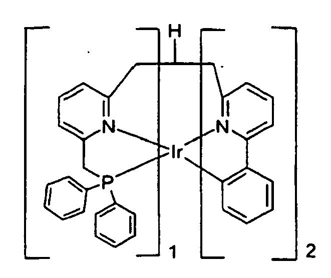 | 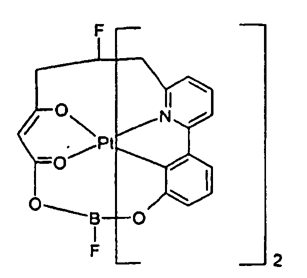 |
| Beispiel 25 | Beispiel 26 | Beispiel 27 |
| 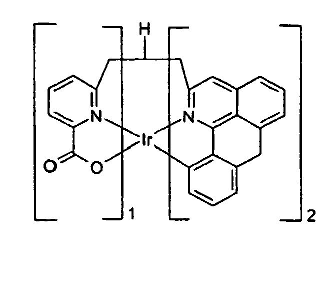 | 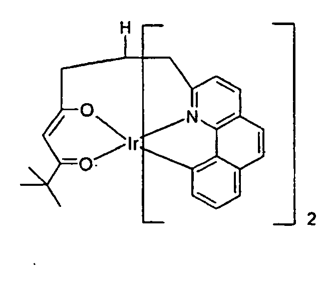 | 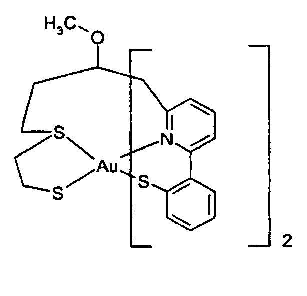 |
| Beispiel 28 | Beispiel 29 | Beispiel 30 |
| 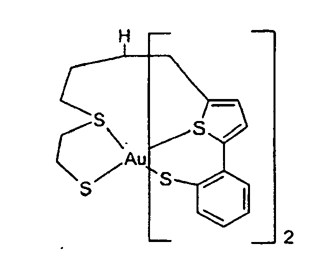 | 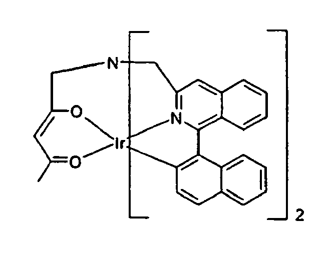 | 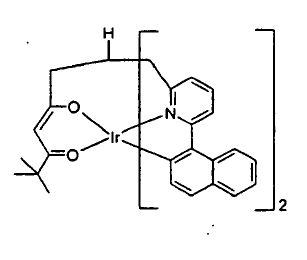 |
| Beispiel 31 | Beispiel 32 | Beispiel 33 |
| 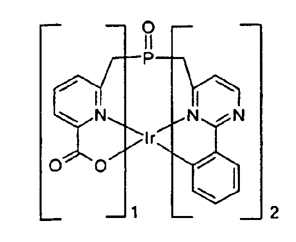 | 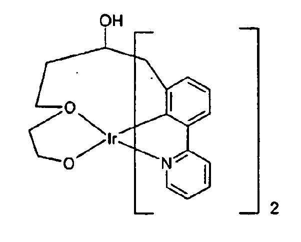 | 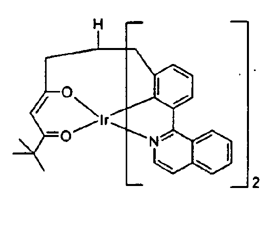 |
| Beispiel 34 | Beispiel 35 | Beispiel 36 |
| 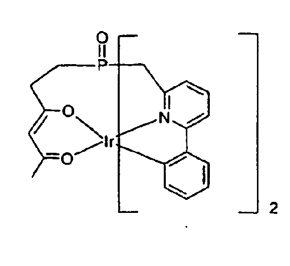 | 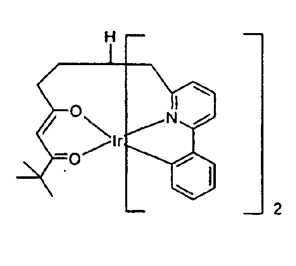 | 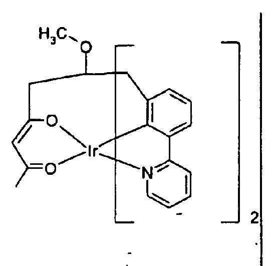 |
| Beispiel 37 | Beispiel 38 | Beispiel 39 |
| 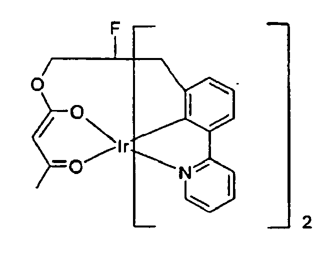 | 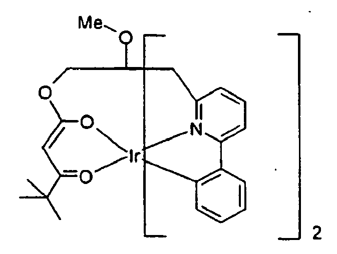 | 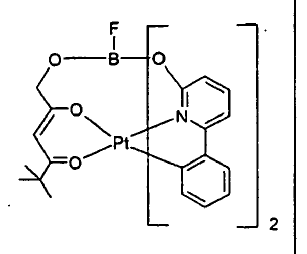 |
| Beispiel 40 | Beispiel 41 | Beispiel 42 |

Die oben beschriebenen erfindungsgemäßen Verbindungen - z. B. Verbindungen gemäß den Beispielen 2 und 4 - können beispielsweise als Comonomere zur Erzeugung entsprechender konjugierter, teilkonjugierter oder nicht-konjugierter Polymere oder auch als Kern von Dendrimeren Verwendung finden. Die Polymerisation erfolgt dabei bevorzugt über die Halogenfunktionalität. So können sie u. a. in lösliche Polyfluorene (z. B. gemäß EP 842208 oder WO 00/22026), Poly-spirobifluorene (z. B. gemäß EP 707020 oder EP 894107), Poly-para-phenylene (z. B. gemäß WO 92/18552), Poly-carbazole (z. B. gemäß WO 04/070772 und WO 04/113468), Polyvinylcarbazole, Polythiophene (z. B. gemäß EP 1028136), Polydihydrophenanthrene (z. B. gemäß WO 05/014689), Polyindenofluorene (z. B. gemäß den Anmeldungen WO 04/041901 und WO 04/113412), Polyketone (z. B. gemäß der nicht offen gelegten Anmeldung DE 102004003008.1) oder auch in Copolymere aus mehreren dieser Einheiten einpolymerisiert werden.

Weiterer Gegenstand der Erfindung sind somit konjugierte, teilkonjugierte und nicht-konjugierte Polymere oder Dendrimere enthaltend eine oder mehrere Verbindungen gemäß Formel (1), wobei eine oder mehrere Bindungen des Komplexes gemäß Formel (1) zum Polymer oder Dendrimer vorhanden sind.

Weiterhin können die erfindungsgemäßen Metallkomplexe auch weiter funktionalisiert werden und so zu erweiterten Metallkomplexen umgesetzt werden. Hier ist als Beispiel die Funktionalisierung mit Arylboronsäuren gemäß SUZUKI oder mit primären oder sekundären Aminen gemäß HARTWIG-BUCHWALD zu nennen.

Die oben beschriebenen erfindungsgemäßen Komplexe, bzw. Polymere oder Dendrimere enthaltend diese Komplexe, finden Verwendung als aktive Komponenten in elektronischen Bauteilen, wie z. B. organischen Leuchtdioden (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs) organischen Solarzellen (O-SCs), organischen optischen Detektoren, organischen Photorezeptoren, organischen Feld-Quench-Devices (O-FQDs) oder auch organischen Laserdioden (O-Laser).

Aktive Komponenten sind beispielsweise Ladungsinjektions-, Ladungstransport- oder Ladungsblockiermaterialien, insbesondere aber Emissionsmaterialien. Für diese Funktion zeigen die erfindungsgemäßen Verbindungen besonders gute Eigenschaften, wie vorne schon erläutert und im Folgenden noch näher ausgeführt wird.

Gegenstand der Erfindung ist also weiterhin die Verwendung dieser Verbindungen in elektronischen Bauteilen.

Die Verbindungen zeichnen sich durch folgende Vorteile aus:
1. Im Gegensatz zu vielen Metallkomplexen gemäß dem Stand der Technik, die der teilweisen oder vollständigen pyrolytischen Zersetzung bei Sublimation unterliegen, weisen die erfindungsgemäßen Verbindungen eine hohe thermische Stabilität auf. Dies führt bei Verwendung in entsprechenden Vorrichtungen zu einer deutlichen Erhöhung der operativen Lebensdauer. Durch die hohe thermische Stabilität der Komplexe wird deren ressourcenschonender Einsatz möglich.
2. Die erfindungsgemäßen Verbindungen, eingesetzt in Elektrolumineszenzvorrichtungen, führen zu hohen Effizienzen und zu steilen Ström-Spannungs-Kurven.
3. Die erfindungsgemäßen Verbindungen weisen gute, zum Teil exzellente Löslichkeit in organischen Lösemitteln auf. Damit lassen sich diese Materialien leichter aus Lösung reinigen, und sie sind auch aus Lösung durch Beschichtungs- oder Drucktechniken verarbeitbar. Auch bei der üblichen Verarbeitung durch Verdampfen ist diese Eigenschaft von Vorteil, da so die Reinigung der Anlagen bzw. der eingesetzten Hilfsmittel, z. B. Schattenmasken, erheblich erleichtert wird.

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Komplexe herstellen bzw. das erfindungsgemäße Verfahren anwenden.

### Beispiele:

Die nachfolgenden Synthesen wurden, sofern nicht anders angegeben, unter einer Schutzgasatmosphäre durchgeführt. Die Edukte wurden von den Firmen ALDRICH, ABCR (Lösemittel, Anorganika, Natriumtetrahydridoborat, Tri-o-tolylphosphin, 6-Chlor-2-pyridincarbonsäure), bzw. von Lancaster (Pyridin-2-boronsäurepinakolester), bzw. von Heraeus (Iridium(III)chlorid Hydrat) bezogen. Bis(3-brombenzyl)keton wurde nach Literaturmethoden dargestellt (H. Sauriat-Dorizon et al., J. Org. Chem. 2003, 68, 240).

### Beispiel 1: Synthese von 1,3-Bis(3-bromphenyl)-propan-2-ol

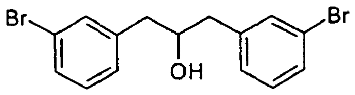

Eine Lösung von 36.8 g (100 mmol) Bis(3-brombenzyl)keton in einem Gemisch aus 500 ml THF, 200 ml *iso*-Propanol und 3 ml Essigsäure wurde bei 0 °C mit 7.6 g (200 mmol) Natriumtetrahydridoborat versetzt und weitere 3 h bei 0 °C gerührt. Abschließend wurde das Eisbad entfernt und weitere 12 h bei Raumtemperatur nachgerührt. Nach Zugabe von 300 ml gesättigter Ammoniumchlorid-Lösung wurde die organische Phase abgetrennt, und die wässrige Phase wurde zweimal mit 100 ml Dichlormethan extrahiert. Die vereinigten organischen Phasen wurden einmal mit 500 ml gesättigter Kochsalzlösung gewaschen und dann im Vakuum vom Lösemittelgemisch befreit. 34.9 g (94 mmol), entsprechend 94.3 % d. Th., des Produkts fielen in Form eines Öls an, 97 %ig nach ¹H-NMR, und wurden ohne Reinigung weiter umgesetzt.
¹H-NMR (CDCl₃): δ [ppm] = 7.31 (d, ³J_{HH}= 8.0 Hz, 2H, H-4), 7.17 (s, 2H, H-2), 7.11 (dd, ³J_{HH} = 8.0 Hz, ³J_{HH} = 8.0 Hz, 2H, H-5), 6.87 (d, ³J_{HH} = 8.0 Hz, 2H, H-6), 3.88 (m, 1H, CH), 3.10 (m, 4H, CH₂), 2.56 (br. s, 1H, OH).

### Beispiel 2: Synthese von 1,3-Bis(3-(2-pyridyl)phenyl)propan-2-ol

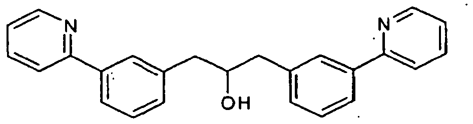

Eine gut gerührte, entgaste Suspension von 33.3 g (90 mmol) 1,3-Bis(3-bromphenyl)-propan-2-ol, 51.3 g (250 mmol) 2-Pyridylboronsäurepinakolester und 40.3 g (380 mmol) Natriumcarbonat in einem Gemisch aus 500 ml Diethoxyethan, 250 ml Ethanol und 350 ml Wasser wurde mit 1.64 g (5.4 mmol) Tri-o-tolylphosphin und anschließend mit 202 mg (0.9 mmol) Palladium(II)acetat versetzt. Nach 16 h Erhitzen der Reaktionsmischung unter Rückfluss wurde die wässrige Phase abgetrennt, die organische Phase wurde mit 500 ml gesättigter Kochsalzlösung gewaschen und anschließend zur Trockene eingeengt. Der ölige Rückstand wurde aus Toluol / Acetonitril umkristallisiert, wobei 26.0 g (71 mmol) der Produkts, mit einer Reinheit von 98 % nach ¹H-NMR, entsprechend einer Ausbeute von 78.8 % d. Th., in Form von farblosen Kristallen anfiel.
¹H-NMR (CDCl₃): δ [ppm] = 7. 76 (m, 4H), 7.61 (m, 4H), 7.35 (dd, ³J_{HH} = 8.0 Hz, ³J_{HH} = 8.0 Hz, 2H), 7.20-7.12 (m, 6H), 3.9.2 (m, 1H, CH), 2.98 (m, 4H, CH₂), 2.30 (br. s, 1H, OH).

### Beispiel 3: Synthese von 2-(6-Pyridincarbonsäure)-2-(1,3-bis(3-pyridyl-phenyl)propyl-ether

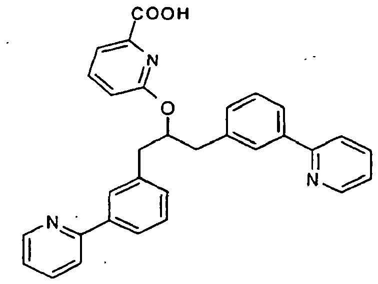

Eine Suspension von 6.2 g (260 mmol) Natriumhydrid in 200 ml DMSO wurde bei 0 °C portionsweise mit 15.8 g (100 mmol) 6-Chlor-2-pyridincarbonsäure versetzt. Nach beendeter Wasserstoffentwicklung wurde zu dieser Suspension eine Lösung von 18.3 g (50 mmol) 1,3-Bis(3-(2-pyridyl)phenyl)propan-2-ol in 50 ml DMSO zugetropft. Nach beendeter Wasserstoffentwicklung wurde die Reaktionsmischung 60 h auf 135 °C erhitzt. Nach Erkalten wurde die Reaktionsmischung vorsichtig durch Zugabe von 1000 ml Wasser hydrolysiert, durch Zugabe von Salzsäure auf pH = 7 eingestellt und fünfmal mit 200 ml Dichlormethan extrahiert. Die vereinigten organischen Extrakte wurde fünfmal mit Wasser gewaschen. Der nach Entfernen des Lösungsmittels verbliebene wachsartige Feststoff wurde durch Chromatographie gereinigt (Kieselgel, Dichlormethan : Methanol 10 : 1). Die Ausbeute bei einer Reinheit von 99 % betrug 9.3 g (19 mmol), entsprechend 38.1 % d. Th..
¹H-NMR (DMSO-d6): δ [ppm) = 12.2 (br. s, 1H, COOH), 7.79 - 7.65 (m, 10H), 7.33-7.26 (m, 3H), 7.14-7.01 (m, 6H), 4.13 (m, 1H. CH), 3.37 (m, 4H, CH₂).

### Beispiel 4: Synthese des Iridium-Komplexes

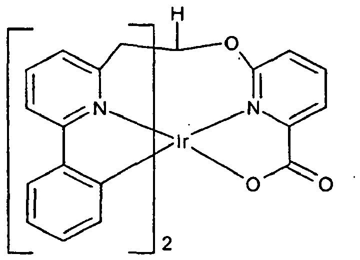

Ein Lösung von 2.44 g (5.0 mmol) 2-(6-Pyridincarbonsäure)-2-(1,3-bis(3-pyridyl-phenyl)propyl-ether und 1.76 g (5.0 mmol) Iridium(III)chlorid Hydrat - berechnet als IrCl₃ x 3 H₂O - in einem Gemisch aus 100 ml Ethoxyethanol und 25 ml Wasser wurde 20 h unter Rückfluss erhitzt. Nach Erkalten der Reaktionsmischung wurde der gelbe, feinkristalline Niederschlag abgesaugt, dreimal mit 20 ml eines Gemischs aus Ethanol / Wasser (1:1, v : v) und dreimal mit 20 ml Ethanol gewaschen und dann getrocknet. Dreimalige Umkristallisation aus DMSO ergab 2:17 g (3.2 mmol), entsprechend 64.1 % d. Th., des Produkts mit einer Reinheit von > 99.8 % nach HPLC.
MS (FAB): m/e = 677.4.

### Beispiel 5: Vergleich der thermischen Stabilität

Der in Beispiel 4 beschriebene Iridiumkopmlex (Molgewicht 677.4 g/mol) wurde im Vakuum bei 340 °C sublimiert. Die Sublimation verlief rückstandsfrei und ohne Anzeichen von Zersetzung, überprüft durch HPLC. Lagerversuche bei 340 °C für 160 h in abgeschmolzenen Ampullen ergaben ebenfalls keinen Hinweis auf eine thermisch induzierte Zersetzung des Iridiumkomplexes nach Beispiel 4.
Im Vergleich dazu besitzt der analoge, nicht polypodale Iridiumkomplex nach WO 02/015645 (CAS: 376367-93-0, Vergleichsbeispiel gemäß dem Stand der Technik, Molgewicht = 694.7 g/mol) eine deutlich geringere thermische Stabilität, obwohl die Einführung von Fluor in die Phenylpyridinliganden sich positiv auf die thermische Stabilität auswirken soll. Die Sublimation dieses Komplexes mit einer Anfangsreinheit nach ¹H-NMR und HPLC von größer 99.9 % bei T = 340°C und p = 5 x 10⁻⁵ mbar ergab nach 2 h:
- ca. 13 Gew.-% einer iridiumhaltigen Asche,
- ca. 83 Gew.% eines gelben Sublimats,
- ca. 7 Gew.% organisches Kondensat, enthaltend unter anderem Pyridin-2-carbonsäure, bestimmt nach ¹H-NMR.
Das gelbe Sublimat war nicht einheitlich. Es bestand nach ¹H-NMR und HPLC aus einem Gemisch. Lagerversuche bei 340 °C für 160 h führten zu einer nahezu vollständigen Zersetzung dieses Komplexes.

Diese Ergebnisse zeigen, dass der erfindungsgemäße Iridiumkoplex-nach Beispiel 4 eine ausgezeichnete Langzeitstabilität aufweist und daher für den industriellen Einsatz bestens geeignet ist. Insbesondere ist die Langzeittemperaturstabilität des erfindungsgemäßen Iridiumkoplexes nach Beispiel 4 deutlich höher als die des Vergleichskomplexes gemäß dem Stand der Technik.
Dabei sind die erfindungsgemäßen Komplexe in der Elektrolumineszenz vergleichbar oder besser als Komplexe gemäß dem Stand der Technik.

## Patentansprüche

1. Organisches elektronisches Bauteil ausgewählt aus der Gruppe bestehend aus organischen Leuchtdioden (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs) oder organischen Laserdioden (O-Laser), enthaltend einen oder mehrere Metallkomplexe gemäß Formel (1), 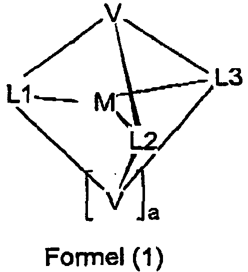 enthaltend mindestens ein Metall M, koordiniert an einen polypodalen Liganden L gemäß Formel (2), 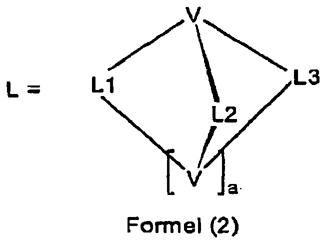 wobei V eine verbrückende Einheit ist, enthaltend 1 bis 80 Atome aus der dritten, vierten, fünften und/oder sechsten Hauptgruppe, die die drei Teilliganden L1, L2 und L3 kovalent miteinander verbindet, und wobei der Index a gleich 0 oder 1 ist,
wobei im Fall a = 0 die verbrückende Einheit V entfällt;
dabei genügt der Teilligand L1 der Formel (3), 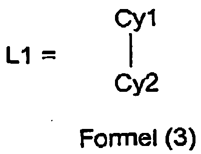 wobei Cy1 und Cy2 substituierte oder unsubstituierte cyclische Gruppen sind, die jeweils mindestens ein Donoratom oder ein C-Atom im Ring oder exocyclisch gebunden enthalten, über welches die cyclische Gruppe an das Metall gebunden ist; die Gruppen Cy1 und Cy2 sind über eine kovalente Bindung oder eine gemeinsame Kante miteinander verbunden und können zusätzlich über Substituenten miteinander verknüpft sein und so ein polycyclisches, aliphatisches oder aromatisches Ringsystem aufspannen;
der Teilligand L2 ist ein Donorligand, enthaltend ein oder mehrere Donoratome und 2 bis 40 C-Atome, mit der Maßgabe, dass der Teilligand L2 nicht aus zwei Cyclen oder Teilcyclen, die beide an das Metall binden, aufgebaut ist;
der Teilligand L3 ist gleich oder verschieden dem Teilliganden L1 oder dem Teilliganden L2,
oder enthaltend ein oder mehrere konjugierte, teilkonjugierte und nicht-konjugierte Polymere oder Dendrimere enthaltend einen oder mehrere Komplexe gemäß Formel 1, wobei eine oder mehrere Bindungen der Komplexe zum Polymer oder Dendrimer vorhanden sind.

2. Organisches elektronisches Bauteil gemäß Anspruch 1, **dadurch gekennzeichnet, dass** die cyclischen Gruppen Cy1 und Cy2 aromatisch sind.

3. Organisches elektronisches Bauteil gemäß Anspruch 1 und/oder Anspruch 2, **dadurch gekennzeichnet, dass** die Metallkomplexe gemäß Formel (1) elektrisch neutral sind.

4. Organisches elektronisches Bauteil gemäß einem oder mehreren der Ansprüche 1 bis 3, **dadurch gekennzeichnet, dass** die Summe der Valenzelektronen um das Metallatom 18 beträgt.

5. Organisches elektronisches Bauteil gemäß einem oder mehreren der Ansprüche 1 bis 4, **dadurch gekennzeichnet, dass** Cy1 ungleich Cy2 ist und einer der beiden Cyclen über eine Metall-Kohlenstoff-Bindung und der andere über ein Donoratom ungleich Kohlenstoff an das Metall bindet.

6. Organisches elektronisches Bauteil gemäß einem oder mehreren der Ansprüche 1 bis 5, **dadurch gekennzeichnet, dass** die verbrückende Einheit V 1 bis 80 Atome aus der 3., 4., 5. und/oder 6. Hauptgruppe oder einen 3- bis 6-gliedrigen Homo- oder Heterocyclus aufweist.

7. Organisches elektronisches Bauteil gemäß einem oder mehreren der Ansprüche 1 bis 6, **dadurch gekennzeichnet, dass** der Teilligand L2 ein zweizähnig chelatisierender Ligand mit zwei Donoratomen ist.

8. Organisches elektronisches Bauteil gemäß einem oder mehreren der Ansprüche 1 bis 7, **dadurch gekennzeichnet, dass** der Ligand L eine Struktur gemäß Formel (4) aufweist 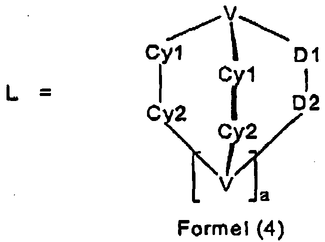 wobei die Symbole D1 und D2, jeweils gleich oder verschieden, für Donorgruppen, enthaltend jeweils ein Donoratom, stehen; die weiteren verwendeten Symbole und Indizes haben die in Anspruch 1 genannten Bedeutungen.

9. Organisches elektronisches Bauteil gemäß einem oder mehreren der Ansprüche 1 bis 8, **dadurch gekennzeichnet, dass** der Teilligand L1 zusammen mit dem Metall M und der verbrückenden Einheit V eine Teilstruktur gemäß den Formeln (5) bis (16) aufweist: 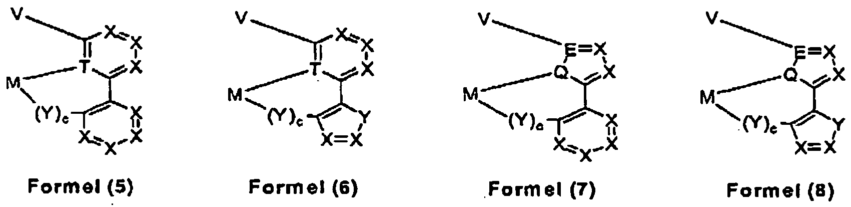 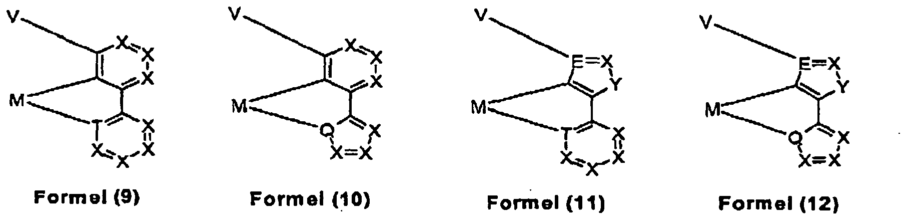 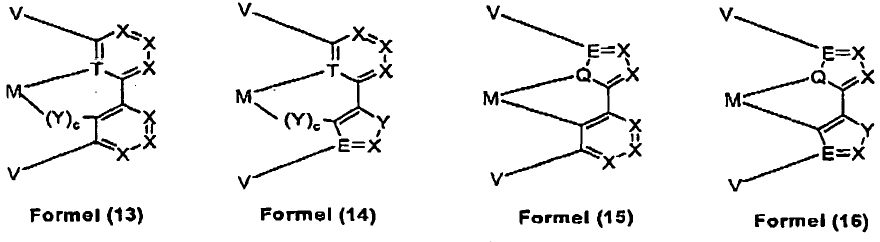 wobei die Symbole und Indizes folgende Bedeutung haben:
M ist gleich oder verschieden bei jedem Auftreten ein Übergangsmetall;
E ist gleich oder verschieden bei jedem Auftreten C, N oder P;
Q ist gleich oder verschieden bei jedem Auftreten O, S, Se, Te oder N;
T ist gleich oder verschieden bei jedem Auftreten N, P oder C;
X ist gleich oder verschieden bei jedem Auftreten CR, N oder P;
Y ist gleich oder verschieden bei jedem Auftreten NR¹, O, S, Se, Te, SO, SeO, TeO, SO₂, SeO₂, TeO₂, R¹SO, R¹SeO, R¹TeO, R¹SO₂, R¹SeO₂, R¹TeO₂, R¹PO oder (R¹)₂PO;
V ist gleich oder verschieden bei jedem Auftreten B, BR⁻, B(CR₂)₃, RB(CR₂)₃⁻, B(O)₃, RB(O)₃⁻, B(CR₂CR₂)₃, RB(CR₂CR₂)₃⁻, B(CR₂O)₃, RS(CR₂O)₃⁻, B(OCR₂)₃, RB(OCR₂)₃⁻, Al(O)₃, RAl(O)₃⁻, Al(OCR₂)₃, RAl(OCR₂)₃⁻, CR, CO⁻, CN(R¹)₂, RC(CR₂)₃, RC(O)₃, RC(CR₂CR₂)₃, RC(CR₂O)₃, RC(OCR₂)₃, RC(SiR₂)₃, RC(SiR₂CR₂)₃, RC(CR₂SiR₂)₃, RC(SiR₂SiR₂)₃, SiR, RSi(CR₂)₃, RSi(O)₃, RSi(CR₂CR₂)₃, RSi(OCR₂)₃, RSi(CR₂O)₃, RSi(SiR₂)₃, RSi(SiR₂CR₂)₃, RSi(CR₂SiR₂)₃, RSi(SiR₂SiR₂)₃, N, NO, NR⁺, N(CR₂)₃, RN(CR₂)₃⁺, N(C=O)₃, N(CR₂CR₂)₃, RN(CR₂CR₂)⁺, P, PO, PS, PSe, PTe, P(O)₃, PO(O)₃, P(OCR₂)₃, PO(OCR₂)₃, P(CR₂)₃, PO(CR₂)₃, P(CR₂CR₂)₃, PO(CR₂CR₂)₃, As, AsO, AsS, AsSe, AsTe, As(O)₃, AsO(O)₃, As(OCR₂)₃, AsO(OCR₂)₃, As(CR₂)₃, AsO(CR₂)₃. As(CR₂CR₂)₃, AsO(CR₂CR₂)₃, Sb, SbO, SbS, SbSe, SbTe, Sb(O)₃, SbO(O)₃, Sb(OCR₂)₃, SbO(OCR₂)₃, Sb(CR₂)₃, SbO(CR₂)₃, Sb(CR₂CR₂)₃, SbO(CR₂CR₂)₃, Bi, BiO, BiS, BiSe, BiTe, Bi(O)_{3,} BiO(O)₃, Bi(OCR₂)₃, BiO(OCR₂)₃, Bi(CR₂)₃, BiO(CR₂)₃, Bi(CR₂CR₂)₃, BiO(CR₂CR₂)₃, S⁺, S(CR₂)₃⁺, S(CR₂CR₂)₃⁺, Se⁺, Se(CR₂)₃⁺, Se(CR₂GR₂)₃⁺, Te⁺, Te(CR₂)₃⁺, Te(CR₂CR₂)₃⁺ oder entsprechende unsymmetrische Analoga; oder eine Einheit gemäß Formel (17) oder Formel (18), 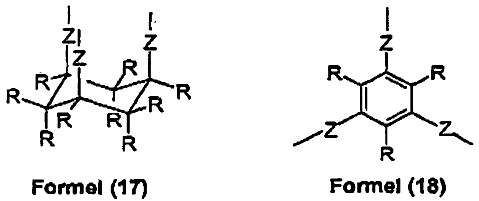
Z ist bei jedem Auftreten gleich oder verschieden eine bivalente Gruppe CR₂, NR, O, S, SiR₂, PR, CR₂-CR₂, CR₂-NR, CR₂-O, CR₂-S, CR₂-SiR₂ oder CR₂-PR;
R ist gleich oder verschieden bei jedem Austreten H, F, Cl, Br, I, NO₂, CN, eine geradkettige, verzweigte oder cyclische Alkyl- oder Alkoxygruppe mit 1 bis 20 C-Atomen, wobei eine oder mehrere nicht benachbarte CH₂-Gruppen durch -R¹C=CR¹-, -C≡C-, Si(R¹)₂, Ge(R¹)₂, Sn(R¹)₂, C=O, C=S, C=Se, G=NR¹, -O-, -S-, -NR¹- oder -CONR¹- ersetzt sein können und wobei ein oder mehrere H-Atome durch F ersetzt sein können, oder eine Aryl-, Aryloxy- oder Heteroarylgruppe mit 1 bis 14 C-Atomen, die durch einen oder mehrere nicht aromatische Reste R substituiert sein kann, oder eine Diarylaminogruppe mit 6 bis 20 C-Atomen, die durch einen oder mehrere nicht aromatische Reste R substituiert sein kann; dabei können mehrere Substituenten R, sowohl am selben Ring als auch an den beiden unterschiedlichen Ringen zusammen wiederum ein weiteres mono- oder polycyclisches, aliphatisches, aromatisches und/oder benzoannelllertes Ringsystem aufspannen;
R¹ ist gleich oder verschieden bei jedem Auftreten H oder ein aliphatischer oder aromatischer Kohlenwasserstoffrest mit 1 bis 20 C-Atomen;
c ist gleich oder verschieden bei jedem Auftreten 0 oder 1.

10. Organisches elektronisches Bauteil gemäß Anspruch 9, **dadurch gekennzeichnet, dass** M bei jedem Auftreten gleich oder verschieden für ein Übergangsmetallion mit der Ordnungszahl größer 38 steht

11. Organisches elektronisches Bauteil gemäß Anspruch 9 und/oder 10, **dadurch gekennzeichnet, dass** Q bei jedem Auftreten gleich oder verschieden für O, S oder N steht.

12. Organisches elektronisches Bauteil gemäß einem oder mehreren der Ansprüche 9 bis 11, **dadurch gekennzeichnet, dass** E bei jedem Auftreten gleich oder verschieden für C oder N steht.

13. Organisches elektronisches Bauteil gemäß einem oder mehreren der Ansprüche 9 bis 12, **dadurch gekennzeichnet, dass** T bei jedem Auftreten gleich oder verschieden für N oder P steht

14. Organisches elektronisches Bauteil gemäß einem oder mehreren der Ansprüche 9 bis 13, **dadurch gekennzeichnet, dass** X bei jedem Auftreten gleich oder verschieden für CR oder N steht.

15. Organisches elektronisches Bauteil gemäß einem oder mehreren der Ansprüche 9 bis 14, **dadurch gekennzeichnet, dass** V bei jedem Auftreten gleich oder verschieden für B, BR⁻, B(CR₂)₃, RB(CR₂)₃⁻, B(O)₃, RB(O)₃⁻, B(CR₂CR₂)₃, B(OCR₂)₃, RB(OCR₂)₃⁻, CR, CNR¹₂, RC(CR₂)₃, RC(O)₃, RC(CR₂CR₂)₃, RC(CR₂O)₃, RC(OCR₂)₃, SiR, RSi(CR₂)₃, RSi(O)₃, RSi(CR₂CR₂)₃, RSi(OCR₂)₃, RSi(CR₂O)₃, N, NR⁺, N(CR₂)₃, RN(CR₂)₃⁺, N(C=O)₃, N(CR₂CR₂)₃, RN(CR₂CR₂)⁺, P, PO, P(O)₃, PO(O)₃, P(OCR₂)₃, PO(OCR₂)₃, S⁺, S(CR₂)₃⁺, S(CR₂CR₂)₃⁺ oder entsprechende unsymmetrische Analoga oder eine Gruppe gemäß Formel (17) oder Formel (18) steht.

16. Organisches elektronisches Bauteil gemäß einem oder mehreren der Ansprüche 9 bis 15, **dadurch gekennzeichnet, dass** Z bei jedem Auftreten gleich oder verschieden für eine bivalente Gruppe CR₂, NR, O, S, SiR₂ oder PR steht.

17. Organisches elektronisches Bauteil gemäß einem oder mehreren der Ansprüche 9 bis 16, **dadurch gekennzeichnet, dass** Y bei jedem Auftreten gleich oder verschieden für O**,** S oder NR¹ steht.

18. Organisches elektronisches Bauteil gemäß einem oder mehreren der Ansprüche 9 bis 17, **dadurch gekennzeichnet, dass** R bei jedem Auftreten gleich oder verschieden für H, F, Cl, Br, I, CN, eine geradkettige, verzweigte oder cyclische Alkyl- oder Alkoxygruppe mit 1 bis 6 C-Atomen oder eine Aryl-, Aryloxy- oder Heteroarylgruppe mit 3 bis 8 C-Atomen, die durch einen oder mehrere nichtaromatische Reste R substituiert sein kann, oder eine Diarylaminogruppe mit 8 bis 12 C-Atomen, die durch einen oder mehrere nicht aromatische Reste R substituiert sein kann, steht; dabei können zwei oder mehrere Substituenten R, sowohl am selben Ring als auch an den beiden unterschiedlichen Ringen zusammen wiederum ein weiteres mono- oder polycyclisches, aliphatisches, aromatisches und/oder benzoannelliertes Ringsystem aufspannen.

19. Organisches elektronisches Bauteil gemäß einem oder mehreren der Ansprüche 9 bis 18, **dadurch gekennzeichnet, dass** c bei jedem Auftreten gleich 0 ist.

20. Organisches elektronisches Bauteil gemäß einem oder mehreren der Ansprüche 1 bis 19, **dadurch gekennzeichnet, dass** die Teilliganden L2 zweizähnig chelatisierende Liganden sind, die zwei Donorgruppen D1 und D2 aufweisen, wobei die Donoratome ausgewählt sind aus der 5. und 6. Hauptgruppe oder Isonitilgruppen darstellen, aber ansonsten keine direkten Metall-Kohlenstoff Bindungen aufweisen; dabei dürfen die Donorgruppen D1 und D2 nicht beide cyclische Systeme darstellen, die beide an das Metall binden.

21. Organisches elektronisches Bauteil gemäß Anspruch 20, **dadurch gekennzeichnet, dass** die Donoratome der Donorgruppen D1 und D2 Stickstoff, Phosphor, Sauerstoff oder Schwefel sind.

22. Organisches elektronisches Bauteil gemäß Anspruch 21, **dadurch gekennzeichnet, dass** die Donorgruppen D1 und D2 aromatische Stickstoffheterocyclen, aliphatische Amine, aliphatische cyclische Amine, Nitrile, Amide, Imide, Imine, Alkyl-, Aryl- oder gemischte Alkylarylphosphine, Alkylhalogen-, Arylhalogen- oder gemischte Alkylarylhalogenphosphine, Alkyl-, Aryl- oder gemischte Alkylarylphosphite, Phosphaaromaten, Alkohole, Alkoholate, offenkettige oder cyclische Ether, Carbonylgruppen, Phosphinoxidgruppen, Sulfoxidgruppen, Carboxylate, Phenole, Phenolate, Oxime, Hydroxamate, β-Ketoketonate, β-Ketoester, β-Diester, aliphatische oder aromatische Thiole und Thiolate, offenkettige oder cyclische Thioether, Thiophen, Thiocarbonylgruppen, Phosphinsulfide oder Thiocarboxylate sind, die jeweils mit Gruppen R substituiert oder unsubstituiert sein können.

23. Organisches elektronisches Bauteil gemäß Anspruch 22, **dadurch gekennzeichnet, dass** die Teilliganden L2 durch R substituierte oder unsubstituierte β-Ketoketonate. β-Ketoester, β-Diester, Pyridyl-carboxylate, α-Aminosäuren, Iminoacetoacetonate, Hydroxamate, Diphosphine, Pyridylphosphine, α-Phosphinocarboxylate, Glycolether, Etheralkoholate, Diamine, Imine, Diimine, Carboxylate abgeleitet von Aminocarbonsäuren, Salicyliminate, Dialkoholate, Dithiolate sind.

24. Metallkomplexe gemäß Formel (1), 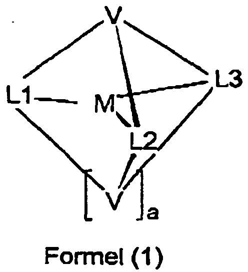 enthaltend mindestens ein Metall M, koordiniert an einen polypodalen Liganden L gemäß Formel (2), 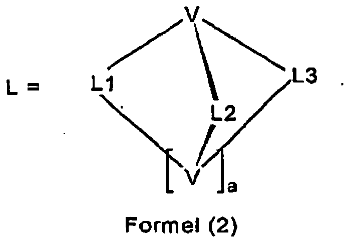 wobei V eine verbrückende Einheit ist, enthaltend 1 bis 80 Atome aus der dritten, vierten, fünften und/oder sechsten Hauptgruppe, die die drei Teilliganden L1, L2 und L3 kovalent miteinander verbindet, und wobei der Index a gleich 0 oder 1 ist, wobei im Fall a = 0 die verbrückende Einheit V entfällt;
dabei genügt der Teilligand L1 der Formel (3), 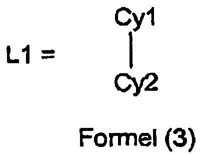 wobei Cy1 und Cy2 substituierte oder unsubstituierte cyclische Gruppen sind, die jeweils mindestens ein Donoratom oder ein C-Atom im Ring oder exocyclisch gebunden enthalten, über welches die cyclische Gruppe an das Metall gebunden ist; die Gruppen Cy1 und Cy2 sind über eine kovalente Bindung oder eine gemeinsame Kante miteinander verbunden und können zusätzlich über Substituenten miteinander verknüpft sein und so ein polycyclisches, aliphatisches oder aromatisches Ringsystem aufspannen;
der Teilligand L2 ist ein Donortigand, enthaltend ein oder mehrere Donoratome und 2 bis 40 C-Atome, mit der Maßgabe, dass der Teilligand L2 nicht aus zwei Cyclen oder Teilcyclen, die beide an das Metall binden, aufgebaut ist;
der Teilligand L3 ist gleich oder verschieden dem Teilliganden L1 oder dem Teilliganden L2,
**dadurch gekennzeichnet, dass** der Teilligand L2 ein zweizähnig chelatisierender Ligand mit zwei Donoratomen ist, und dass weiterhin entweder der Index a = 0 ist oder dass Cy1 ungleich Cy2 ist und einer der beiden Cyclen über eine Metall-Kohlenstoff-Bindung und der andere über ein Donoratom ungleich Kohlenstoff an das Metall bindet.

25. Metallkomplexe gemäß Anspruch 24, **dadurch gekennzeichnet, dass** der Ligand L eine Struktur gemäß Formel (4) aufweist: 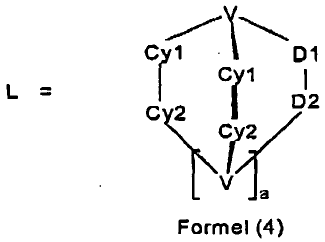 wobei die Symbole D1 und D2, jeweils gleich oder verschieden, für Donorgruppen, enthaltend jeweils ein Donoratom, stehen; die weiteren verwendeten Symbole und Indizes haben die in Anspruch 24 genannten Bedeutungen.

26. Verfahren zur Herstellung von Komplexen gemäß Anspruch 24 oder 25 durch Umsetzung des Liganden gemäß Formel (2) bzw. Vorstufen dieses Liganden mit Metallalkoholaten gemäß Formel (19), mit Metallketoketonaten gemäß Formel (20) oder Metallhalogeniden gemäß Formel (21), 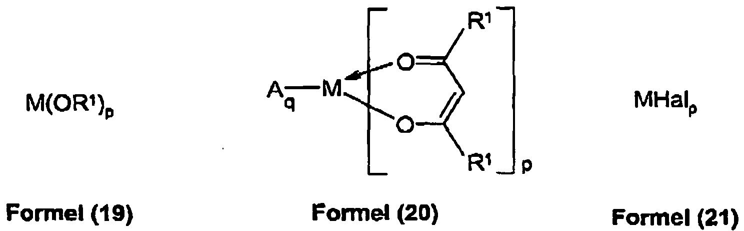 wobei für die Symbole und Indizes gilt
M ist bei jedem Auftreten gleich oder verschieden ein Übergangsmetallion;
Hal ist bei jedem Auftreten gleich oder verschieden F, Cl, Br oder I;
A ist bei jedem Auftreten gleich oder verschieden ein neutraler oder monoanionischer, einzähniger oder zweizähniger Ligand;
p ist bei jedem Auftreten gleich oder verschieden 1, 2, 3, 4 oder 5, wobei p in Formel (19) und (21) die Wertigkeit des Metalls M angibt:
q ist bei jedem Auftreten gleich oder verschieden 0, 1, 2, 3 oder 4;
dabei kann die Verbindung gemäß Formel (20) auch geladen sein und noch ein Gegenion enthalten; die weiteren Symbole haben dieselbe Bedeutung, wie unter Anspruch 9 beschrieben.

27. Verfahren gemäß Anspruch 26, **dadurch gekennzeichnet, dass** die Reaktion thermisch, photochemisch oder durch Mikrowellenstrahlung aktiviert wird.

28. Verfahren gemäß Anspruch 26 und/oder 27, **dadurch gekennzeichnet, dass** der Ligand gemäß Formel (2) mit Metallverbindungen gemäß Formeln (19), (20) und (21) umgesetzt wird:

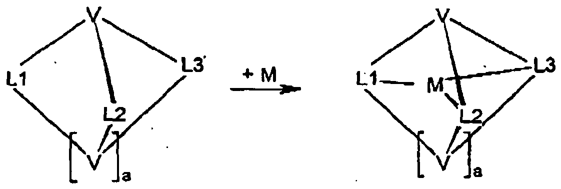

29. Verfahren gemäß Anspruch 26 und/oder 27, dadurch gekennzeichnt, dass eine polypodale Vorstufe des Kryptanden im Komplexierungsschritt eingesetzt und in einem zweiten Syntheseschritt die zweite verbrückende Einheit V eingeführt wird: 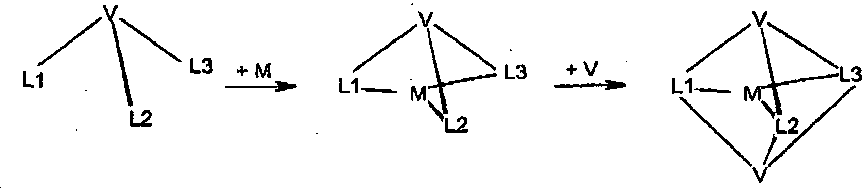 oder dass eine einfache Vorstufe des Liganden eingesetzt wird und alle verbrückenden Einheiten V in einem weiteren Schritt gebildet werden: 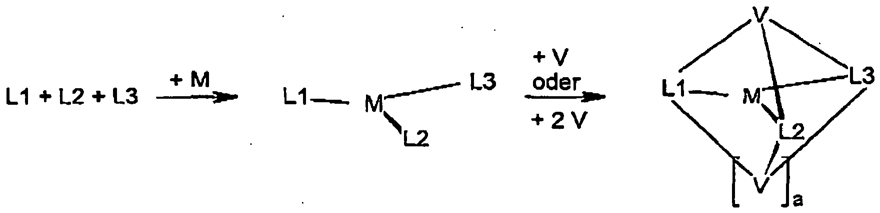 oder dass eine einfache oder makrocyclische Vorstufe des Liganden eingesetzt wird und der dritte Teilligand eingeführt und mit den verbrückenden Einheiten V verknüpft wird:

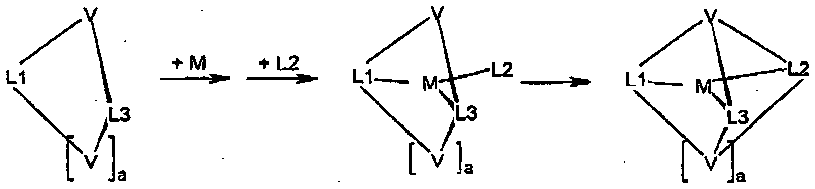

30. Konjugierte, teilkonjugierte und nicht-konjugierte Polymere oder Dendrimere enthaltend einen oder mehrere Komplexe gemäß der folgenden Formel (1), wobei eine oder mehrere Bindungen der Komplexe zum Polymer oder Dendrimer vorhanden sind, 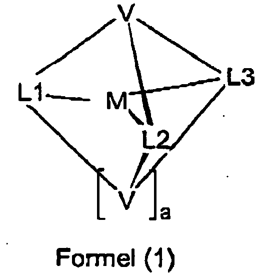 enthaltend mindestens ein Metall M, koordiniert an einen polypodalen Liganden L gemäß Formel (2), 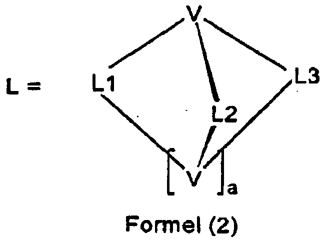 wobei V eine verbrückende Einheit ist, enthaltend 1 bis 80 Atome aus der dritten, vierten, fünften und/oder sechsten Hauptgruppe, die die drei Teilliganden L1, L2 und L3 kovalent miteinander verbindet, und wobei der Index a gleich 0 oder 1 ist, wobei im Fall a = 0 die verbrückende Einheit V entfällt;
dabei genügt der Teilligand L1 der Formel (3), 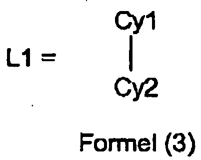 wobei Cy1 und Cy2 substituierte oder unsubstituierte cyclische Gruppen sind, die jeweils mindestens ein Donoratom oder ein C-Atom im Ring oder exocyclisch gebunden enthalten, über welches die cyclische Gruppe an das Metall gebunden ist; die Gruppen Cy1 und Cy2 sind über eine kovalente Bindung oder eine gemeinsame Kante miteinander verbunden und können zusätzlich über Substituenten miteinander verknüpft sein und so ein polycyclisches, aliphatisches oder aromatisches Ringsystem aufspannen;
der Teilligand L2 ist ein Donorligand, enthaltend ein oder mehrere Donoratome und 2 bis 40 C-Atome, mit der Maßgabe, dass der Teilligand L2 nicht aus zwei Cyclen oder Teilcyclen, die beide an das Metall binden, aufgebaut ist;
der Teilligand L3 ist gleich oder verschieden dem Teilliganden L1 oder dem Teilliganden L2.

31. Verwendung von Komplexen gemäß einem oder mehreren der Ansprüche 24, 25 oder 30 in organischen elektronischen Bauteilen.

## Claims

1. Organic electronic component selected from the group consisting of organic light-emitting diodes (OLEDs), organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field-quench devices (O-FQDs) and organic laser diodes (O-lasers), comprising one or more metal complexes of the formula (1), 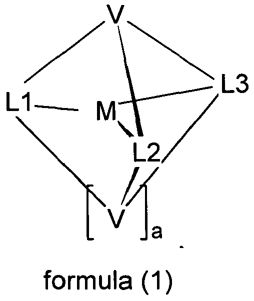 containing at least one metal M, coordinated to a polypodal ligand L of the formula (2), 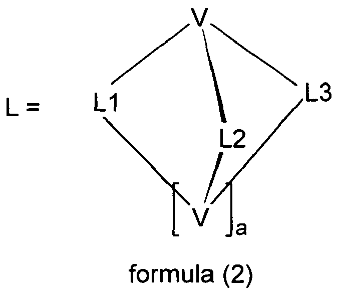 where V is a bridging unit, containing 1 to 80 atoms from the third, fourth, fifth and/or sixth main group, which covalently bonds the three part-ligands L1, L2 and L3 to one another, and where the index a is equal to 0 or 1, where, in the case a = 0, the bridging unit V is omitted;
part-ligand L1 here conforms to the formula (3), 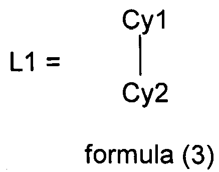 where Cy1 and Cy2 are substituted or unsubstituted cyclic groups, each of which contains at least one donor atom or C atom in the ring or bonded exocyclically via which the cyclic group is bonded to the metal; the groups Cy1 and Cy2 are bonded to one another via a covalent bond or a common edge and may additionally be linked to one another via substituents and thus form a polycyclic, aliphatic or aromatic ring system;
part-ligand L2 is a donor ligand, containing one or more donor atoms and 2 to 40 C atoms, with the proviso that part-ligand L2 is not built up from two rings or part-rings which are both bonded to the metal;
part-ligand L3 is identical to or different from part-ligand L1 or part-ligand L2,
or comprising one or more conjugated, partially conjugated and non-conjugated polymers or dendrimers comprising one or more complexes of the formula 1, where one or more bonds are present from the complexes to the polymer or dendrimer.

2. Organic electronic component according to Claim 1, **characterised in that** the cyclic groups Cy1 and Cy2 are aromatic.

3. Organic electronic component according to Claim 1 and/or Claim 2, **characterised in that** the metal complexes of the formula (1) are electrically neutral.

4. Organic electronic component according to one or more of Claims 1 to 3, **characterised in that** the sum of the valence electrons around the metal atom is 18.

5. Organic electronic component according to one or more of Claims 1 to 4, **characterised in that** Cy1 is not equal to Cy2, and one of the two rings is bonded to the metal via a metal-carbon bond and the other is bonded to the metal via a donor atom other than carbon.

6. Organic electronic component according to one or more of Claims 1 to 5, **characterised in that** the bridging unit V has 1 to 80 atoms from main group 3, 4, 5 and/or 6 or a 3- to 6-membered homo- or heterocycle.

7. Organic electronic component according to one or more of Claims 1 to 6, **characterised in that** part-ligand L2 is a bidentate-chelating ligand having two donor atoms.

8. Organic electronic component according to one or more of Claims 1 to 7, **characterised in that** the ligand L has a structure of the formula (4): 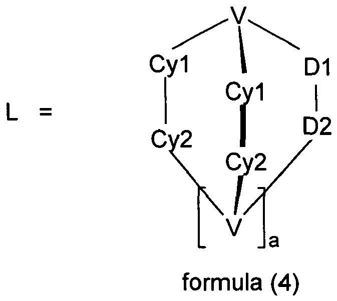 where the symbols D1 and D2, in each case identically or differently, stand for donor groups, each containing one donor atom; the other symbols and indices used have the meanings mentioned in Claim 1.

9. Organic electronic component according to one or more of Claims 1 to 8, **characterised in that** part-ligand L1 together with the metal M and the bridging unit V has a part-structure of the formulae (5) to (16): 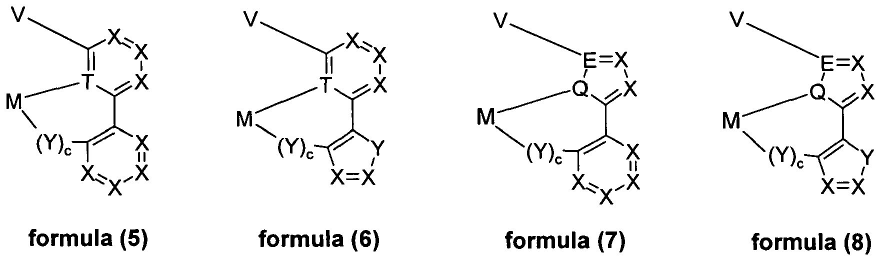 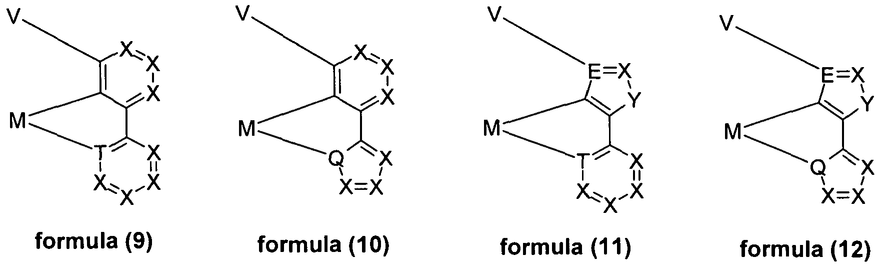 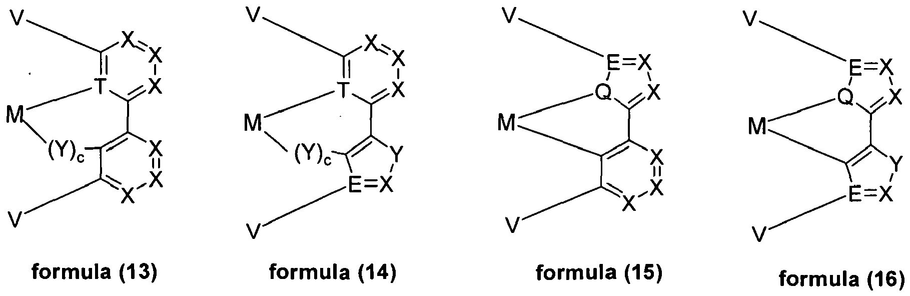 where the symbols and indices have the following meaning:
M is, identically or differently on each occurrence, a transition metal;
E is, identically or differently on each occurrence, C, N or P;
Q is, identically or differently on each occurrence, O, S, Se, Te or N;
T is, identically or differently on each occurrence, N, P or C;
X is, identically or differently on each occurrence, CR, N or P;
Y is, identically or differently on each occurrence, NR¹, O, S, Se, Te, SO, SeO, TeO, SO₂, SeO₂, TeO₂, R¹SO, R¹SeO, R¹TeO, R¹SO₂, R¹SeO₂, R¹TeO₂, R¹PO or (R¹)₂PO;
V is, identically or differently on each occurrence, B, BR⁻, B(CR₂)₃, RB(CR₂)₃⁻, B(O)₃, RB(O)₃⁻, B(CR₂CR₂)₃, RB(CR₂CR₂)₃⁻, B(CR₂O)₃, RB(CR₂O)₃⁻, B(OCR₂)₃, RB(OCR₂)₃⁻, Al(O)₃, RAl(O)₃⁻, Al(OCR₂)₃, RAl(OCR₂)₃⁻, CR, CO⁻, CN(R¹)₂, RC(CR₂)₃, RC(O)₃, RC(CR₂CR₂)₃, RC(CR₂O)₃, RC(OCR₂)₃, RC(SiR₂)₃, RC(SiR₂CR₂)₃, RC(CR₂SiR₂)₃, RC(SiR₂SiR₂)₃, SiR, RSi(CR₂)₃, RSi(O)₃, RSi(CR₂CR₂)₃, RSi(OCR₂)₃, RSi(CR₂O)₃, RSi(SiR₂)₃, RSi(SiR₂CR₂)₃, RSi(CR₂SiR₂)₃, RSi(SiR₂SiR₂)₃, N, NO, NR⁺, N(CR₂)₃, RN(CR₂)₃⁺, N(C=O)₃, N(CR₂CR₂)₃, RN(CR₂CR₂)⁺, P, PO, PS, PSe, PTe, P(O)₃, PO(O)₃, P(OCR₂)₃, PO(OCR₂)₃, P(CR₂)₃, PO(CR₂)₃, P(CR₂CR₂)₃, PO(CR₂CR₂)₃, As, AsO, AsS, AsSe, AsTe, As(O)₃, AsO(O)₃, As(OCR₂)₃, AsO(OCR₂)₃, As(CR₂)₃, AsO(CR₂)₃, As(CR₂CR₂)₃, AsO(CR₂CR₂)₃, Sb, SbO, SbS, SbSe, SbTe, Sb(O)₃, SbO(O)₃, Sb(OCR₂)₃, SbO(OCR₂)₃, Sb(CR₂)₃, SbO(CR₂)₃, Sb(CR₂CR₂)₃, SbO(CR₂CR₂)₃, Bi, BiO, BiS, BiSe, BiTe, Bi(O)₃, BiO(O)₃, Bi(OCR₂)₃, BiO(OCR₂)₃, Bi(CR₂)₃, BiO(CR₂)₃, Bi(CR₂CR₂)₃, BiO(CR₂CR₂)₃, S⁺, S(CR₂)₃⁺, S(CR₂CR₂)₃⁺, Se⁺, Se(CR₂)₃⁺, Se(CR₂CR₂)₃⁺, Te⁺, Te(CR₂)₃⁺, Te(CR₂CR₂)₃⁺ or corresponding asymmetrical analogues; or a unit of the formula (17) or formula (18), 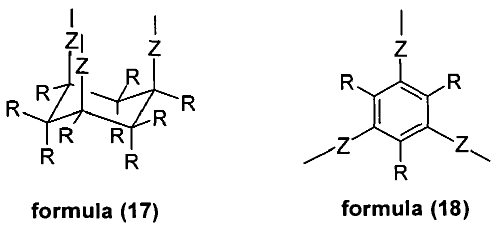
Z is on each occurrence, identically or differently, a divalent group CR₂, NR, O, S, SiR₂, PR, CR₂-CR₂, CR₂-NR, CR₂-O, CR₂-S, CR₂-SiR₂ or CR₂-PR;
R is, identically or differently on each occurrence, H, F, Cl, Br, I, NO₂, CN, a straight-chain, branched or cyclic alkyl or alkoxy group having 1 to 20 C atoms, in which one or more non-adjacent CH₂ groups may be replaced by -R¹C=CR¹-, -C≡C-, Si(R¹)₂, Ge(R¹)₂, Sn(R¹)₂, C=O, C=S, C=Se, C=NR¹, -O-, -S-, -NR¹- or -CONR¹- and in which one or more H atoms may be replaced by F, or an aryl, aryloxy or heteroaryl group having 1 to 14 C atoms, which may be substituted by one or more non-aromatic radicals R, or a diarylamino group having 6 to 20 C atoms, which may be substituted by one or more non-aromatic radicals R; a plurality of substituents R here, both on the same ring and also on the two different rings, may together in turn form a further mono- or polycyclic, aliphatic, aromatic and/or benzo-fused ring system;
R¹ is, identically or differently on each occurrence, H or an aliphatic or aromatic hydrocarbon radical having 1 to 20 C atoms;
c is, identically or differently on each occurrence, 0 or 1.

10. Organic electronic component according to Claim 9, **characterised in that** M on each occurrence, identically or differently, stands for a transition-metal ion having an atomic number of greater than 38.

11. Organic electronic component according to Claim 9 and/or 10, **characterised in that** Q on each occurrence, identically or differently, stands for O, S or N.

12. Organic electronic component according to one or more of Claims 9 to 11, **characterised in that** E on each occurrence, identically or differently, stands for C or N.

13. Organic electronic component according to one or more of Claims 9 to 12, **characterised in that** T on each occurrence, identically or differently, stands for N or P.

14. Organic electronic component according to one or more of Claims 9 to 13, **characterised in that** X on each occurrence, identically or differently, stands for CR or N.

15. Organic electronic component according to one or more of Claims 9 to 14, **characterised in that** V on each occurrence, identically or differently, stands for B, BR⁻, B(CR₂)₃, RB(CR₂)₃⁻, B(O)₃, RB(O)₃⁻, B(CR₂CR₂)₃, B(OCR₂)₃, RB(OCR₂)3 , CR, CNR¹₂, RC(CR₂)₃, RC(O)₃, RC(CR₂CR₂)₃, RC(CR₂O)₃, RC(OCR₂)₃, SiR, RSi(CR₂)₃, RSi(O)₃, RSi(CR₂CR₂)₃, RSi(OCR₂)₃, RSi(CR₂O)₃, N, NR⁺, N(CR₂)₃, RN(CR₂)₃⁺, N(C=O)₃, N(CR₂CR₂)₃, RN(CR₂CR₂)⁺, P, PO, P(O)₃, PO(O)₃, P(OCR₂)₃, PO(OCR₂)₃, S⁺, S(CR₂)₃⁺, S(CR₂CR₂)₃⁺ or corresponding asymmetrical analogues or a group of the formula (17) or formula (18).

16. Organic electronic component according to one or more of Claims 9 to 15, **characterised in that** Z on each occurrence, identically or differently, stands for a divalent group CR₂, NR, O, S, SiR₂ or PR.

17. Organic electronic component according to one or more of Claims 9 to 16, **characterised in that** Y on each occurrence, identically or differently, stands for O, S or NR¹.

18. Organic electronic component according to one or more of Claims 9 to 17, **characterised in that** R on each occurrence, identically or differently, stands for H, F, Cl, Br, I, CN, a straight-chain, branched or cyclic alkyl or alkoxy group having 1 to 6 C atoms or an aryl, aryloxy or heteroaryl group having 3 to 8 C atoms, which may be substituted by one or more non-aromatic radicals R, or a diarylamino group having 8 to 12 C atoms, which may be substituted by one or more non-aromatic radicals R; two or more substituents R here, both on the same ring and also on the two different rings, may together in turn form a further mono- or polycyclic, aliphatic, aromatic and/or benzo-fused ring system.

19. Organic electronic component according to one or more of Claims 9 to 18, **characterised in that** c on each occurrence is equal to 0.

20. Organic electronic component according to one or more of Claims 1 to 19, **characterised in that** part-ligands L2 are bidentate-chelating ligands which have two donor groups D1 and D2, where the donor atoms are selected from main groups 5 and 6 or represent isonitrile groups, but otherwise do not have any direct metal-carbon bonds; the donor groups D1 and D2 here cannot both represent cyclic systems which are both bonded to the metal.

21. Organic electronic component according to Claim 20, **characterised in that** the donor atoms of donor groups D1 and D2 are nitrogen, phosphorus, oxygen or sulfur.

22. Organic electronic component according to Claim 21, **characterised in that** the donor groups D1 and D2 are aromatic nitrogen heterocycles, aliphatic amines, aliphatic cyclic amines, nitriles, amides, imides, imines, alkyl-, aryl- or mixed alkylarylphosphines, alkyl-, aryl- or mixed alkylarylphosphine halides, alkyl, aryl or mixed alkyl aryl phosphites, phosphaaromatics, alcohols, alcoholates, open-chain or cyclic ethers, carbonyl groups, phosphine oxide groups, sulfoxide groups, carboxylates, phenols, phenolates, oximes, hydroxamates, β-ketoketonates, β-ketoesters, β-diesters, aliphatic or aromatic thiols and thiolates, open-chain or cyclic thioethers, thiophene, thiocarbonyl groups, phosphine sulfides or thiocarboxylates, each of which may be substituted by groups R or unsubstituted.

23. Organic electronic component according to Claim 22, **characterised in that** part-ligands L2 are β-ketoketonates, β-ketoesters, β-diesters, pyridylcarboxylates, α-amino acids, iminoacetoacetonates, hydroxamates, diphosphines, pyridylphosphines, α-phosphinocarboxylates, glycol ethers, ether alcoholates, diamines, imines, diimines, carboxylates derived from aminocarboxylic acids, salicyliminates, dialcoholates, dithiolates, each of which are substituted by R or unsubstituted.

24. Metal complexes of the formula (1), 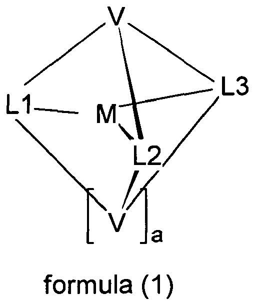 containing at least one metal M, coordinated to a polypodal ligand L of the formula (2), 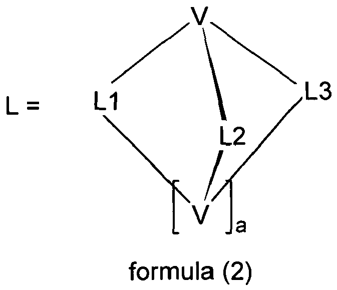 where V is a bridging unit, containing 1 to 80 atoms from the third, fourth, fifth and/or sixth main group, which covalently bonds the three part-ligands L1, L2 and L3 to one another, and where the index a is equal to 0 or 1, where, in the case a = 0, the bridging unit V is omitted;
part-ligand L1 here conforms to the formula (3), 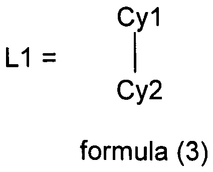 where Cy1 and Cy2 are substituted or unsubstituted cyclic groups, each of which contains at least one donor atom or C atom in the ring or bonded exocyclically via which the cyclic group is bonded to the metal; the groups Cy1 and Cy2 are bonded to one another via a covalent bond or a common edge and may additionally be linked to one another via substituents and thus form a polycyclic, aliphatic or aromatic ring system;
part-ligand L2 is a donor ligand, containing one or more donor atoms and 2 to 40 C atoms, with the proviso that part-ligand L2 is not built up from two rings or part-rings which are both bonded to the metal;
part-ligand L3 is identical to or different from part-ligand L1 or part-ligand L2, **characterised in that** part-ligand L2 is a bidentate-chelating ligand having two donor atoms, and **in that** furthermore either the index a = 0 or **in that** Cy1 is not equal to Cy2, and one of the two rings is bonded to the metal via a metal-carbon bond and the other is bonded to the metal via a donor atom other than carbon.

25. Metal complexes according to Claim 24, **characterised in that** the ligand L has a structure of the formula (4): 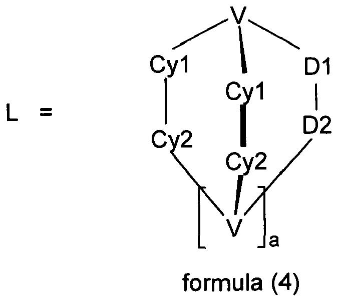 where the symbols D1 and D2, in each case identically or differently, stand for donor groups, each containing one donor atom; the other symbols and indices used have the meanings mentioned in Claim 24.

26. Process for the preparation of complexes according to Claim 24 or 25 by reaction of the ligand of the formula (2) or precursors of this ligand with metal alcoholates of the formula (19), with metal ketoketonates of the formula (20) or metal halides of the formula (21), 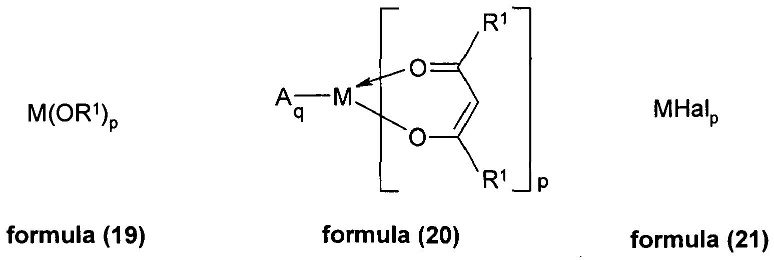 where the following applies to the symbols and indices:
M is on each occurrence, identically or differently, a transition-metal ion;
Hal is on each occurrence, identically or differently, F, Cl, Br or I;
A is on each occurrence, identically or differently, a neutral or monoanionic, monodentate or bidentate ligand;
p is on each occurrence, identically or differently, 1, 2, 3, 4 or 5, where p in formulae (19) and (21) indicates the valence of the metal M;
q is on each occurrence, identically or differently, 0, 1, 2, 3 or 4;
the compound of the formula (20) here may also be charged and may also contain a counterion; the other symbols have the same meaning as described under Claim 9.

27. Process according to Claim 26, **characterised in that** the reaction is activated thermally, photochemically or by microwave radiation.

28. Process according to Claim 26 and/or 27, **characterised in that** the ligand of the formula (2) is reacted with metal compounds of the formulae (19), (20) and (21):

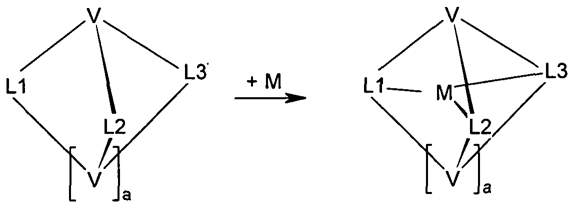

29. Process according to Claim 26 and/or 27, **characterised in that** a polypodal precursor of the cryptand is employed in the complexing step, and the second bridging unit V is introduced in a second synthetic step: 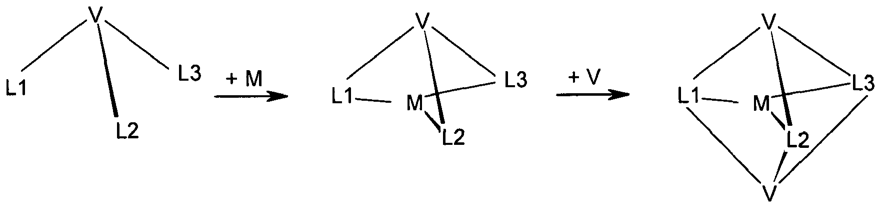 or **in that** a simple precursor of the ligand is employed, and all bridging units V are formed in a further step: 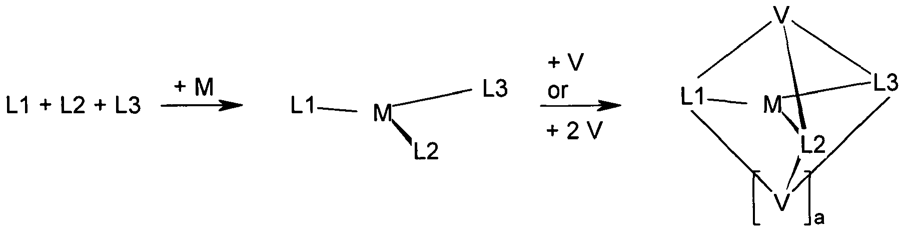 or **in that** a simple or macrocyclic precursor of the ligand is employed, and the third part-ligand is introduced and linked to the bridging units V:

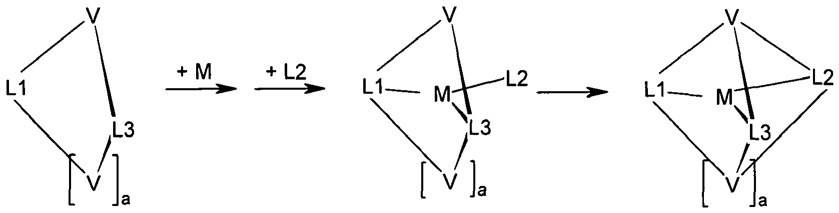

30. Conjugated, partially conjugated and non-conjugated polymers or dendrimers comprising one or more complexes of the following formula (1), where one or more bonds are present from the complexes to the polymer or dendrimer, 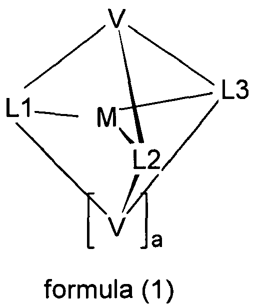 containing at least one metal M, coordinated to a polypodal ligand L of the formula (2), 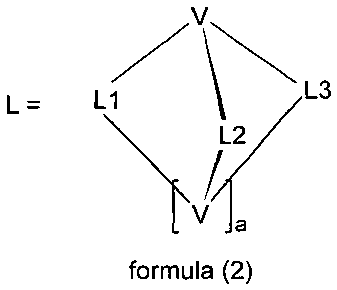 where V is a bridging unit, containing 1 to 80 atoms from the third, fourth, fifth and/or sixth main group, which covalently bonds the three part-ligands L1, L2 and L3 to one another, and where the index a is equal to 0 or 1, where, in the case a = 0, the bridging unit V is omitted;
part-ligand L1 here conforms to the formula (3), 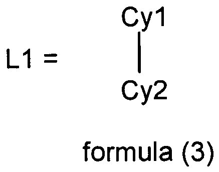 where Cy1 and Cy2 are substituted or unsubstituted cyclic groups, each of which contains at least one donor atom or C atom in the ring or bonded exocyclically via which the cyclic group is bonded to the metal; the groups Cy1 and Cy2 are bonded to one another via a covalent bond or a common edge and may additionally be linked to one another via substituents and thus form a polycyclic, aliphatic or aromatic ring system;
part-ligand L2 is a donor ligand, containing one or more donor atoms and 2 to 40 C atoms, with the proviso that part-ligand L2 is not built up from two rings or part-rings which are both bonded to the metal;
part-ligand L3 is identical to or different from part-ligand L1 or part-ligand L2.

31. Use of complexes according to one or more of Claims 24, 25 or 30 in organic electronic components.

## Revendications

1. Composant électronique organique choisi parmi le groupe constitué par des diodes émettrices de lumière organiques (OLED), des circuits intégrés organiques (O-IC), des transistors à effet de champ organiques (O-FET), des transistors à film mince organiques (O-TFT), des transistors émetteurs de lumière organiques (O-LET), des cellules solaires organiques (O-SC), des détecteurs optiques organiques, des photorécepteurs organiques, des dispositifs à extinction de champ organiques (O-FQD) et des diodes laser organiques (O-laser), comprenant un ou plusieurs complexes métalliques de la formule (1), 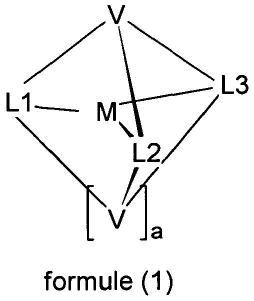 contenant au moins un métal M, coordonné sur un ligand polypodal L de la formule (2), 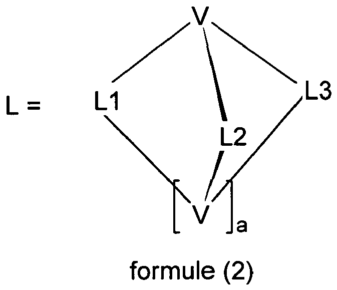 où V est une unité de pontage, contenant de 1 à 80 atomes pris parmi les troisième, quatrième, cinquième et/ou sixième groupes principaux, laquelle unité lie de façon covalente les trois ligands partiels L1, L2 et L3 les uns aux autres, et où l'indice a est égal à 0 ou 1, où, dans le cas où a = 0, l'unité de pontage V est omise ;
le ligand partiel L1 est ici conforme à la formule (3), 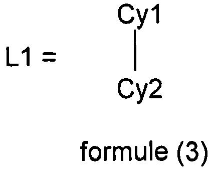 où Cy1 et Cy2 sont des groupes cycliques substitués ou non substitués dont chacun contient au moins un atome de donneur ou un atome de C dans le cycle ou selon une liaison exocyclique via laquelle le groupe cyclique est lié au métal ; les groupes Cy1 et Cy2 sont liés l'un à l'autre via une liaison covalente ou un bord commun et peuvent de façon additionnelle être reliés l'un à l'autre via des substituents et ainsi former un système de cycle polycyclique, aliphatique ou aromatique ;
le ligand partiel L2 est un ligand de donneur, contenant un ou plusieurs atomes de donneur et de 2 à 40 atomes de C, étant entendu que le ligand partiel L2 n'est pas élaboré à partir de deux cycles ou de deux cycles partiels qui sont tous deux liés au métal ;
le ligand partiel L3 est identique au ligand partiel L1 ou au ligand partiel L2 ou en est différent,
ou comprenant un ou plusieurs polymères ou dendrimères conjugués, partiellement conjugués et non conjugués comprenant un ou plusieurs complexes de la formule 1, où une ou plusieurs liaisons sont présentes depuis les complexes sur le polymère ou dendrimère.

2. Composant électronique organique selon la revendication 1, **caractérisé en ce que** les groupes cycliques Cy1 et Cy2 sont aromatiques.

3. Composant électronique organique selon la revendication 1 et/ou la revendication 2, **caractérisé en ce qu'**ils sont électriquement neutres.

4. Composant électronique organique selon une ou plusieurs des revendications 1 à 3, **caractérisé en ce que** la somme des électrons de valence autour de l'atome métallique est de 18.

5. Composant électronique organique selon une ou plusieurs des revendications 1 à 4, **caractérisé en ce que** Cy1 n'est pas égal à Cy2, et l'un des deux cycles est lié au métal via une liaison métal-carbone et l'autre est lié au métal via un atome de donneur autre que le carbone.

6. Composant électronique organique selon une ou plusieurs des revendications 1 à 5, **caractérisé en ce que** l'unité de pontage V comporte de 1 à 80 atomes issus des groupes principaux 3, 4, 5 et/ou 6 ou un homocycle ou hétérocycle à 3 à 6 éléments.

7. Composant électronique organique selon une ou plusieurs des revendications 1 à 6, **caractérisé en ce que** le ligand partiel L2 est un ligand bidenté-chélatant comportant deux atomes de donneur.

8. Composant électronique organique selon une ou plusieurs des revendications 1 à 7, **caractérisé en ce que** le ligand L présente une structure de la formule (4) : 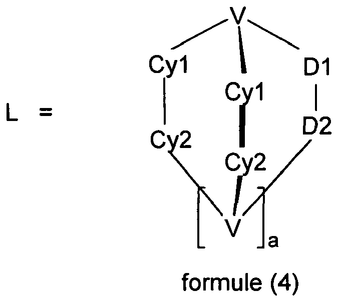 où les symboles D1 et D2, dans chaque cas de manière identique ou différente, représentent des groupes de donneur, chacun contenant un atome de donneur ; les autres symboles et indices utilisés présentent les significations mentionnées selon la revendication 1.

9. Composant électronique organique selon une ou plusieurs des revendications 1 à 8, **caractérisé en ce que** le ligand partiel L1 en association avec le métal M et l'unité de pontage V présente une structure partielle des formules (5) à (16) : 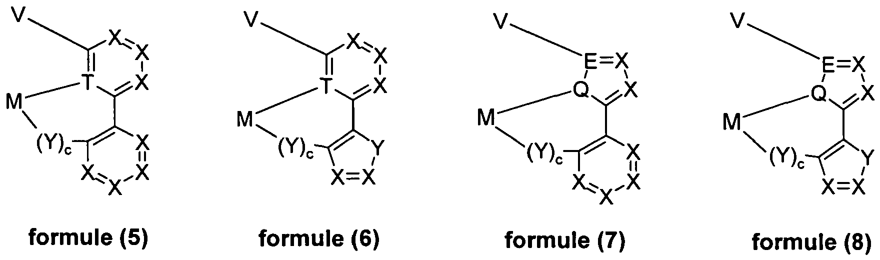 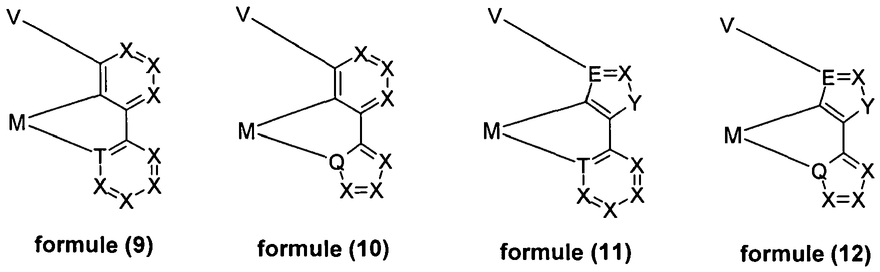 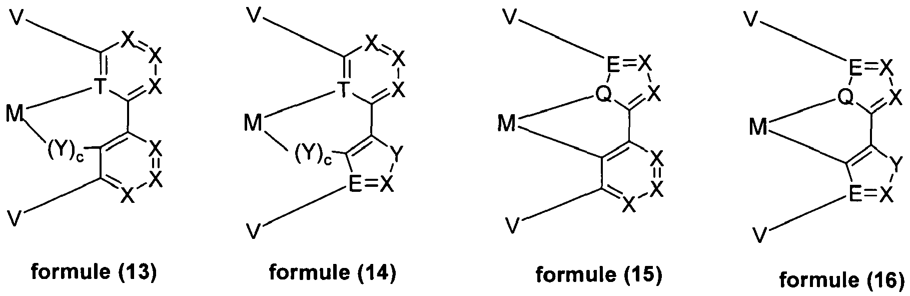 où les symboles et indices présentent la signification qui suit :
M est, de manière identique ou différente pour chaque occurrence, un métal de transition ;
E est, de manière identique ou différente pour chaque occurrence, C, N ou P;
Q est, de manière identique ou différente pour chaque occurrence, O, S, Se, Te ou N ;
T est, de manière identique ou différente pour chaque occurrence, N, P ou C ;
X est, de manière identique ou différente pour chaque occurrence, CR, N ou P;
Y est, de manière identique ou différente pour chaque occurrence, NR¹, O, S, Se, Te, SO, SeO, TeO, SO₂, SeO₂, TeO₂, R¹SO, R¹SeO, R¹TeO, R¹SO₂, R¹SeO₂, R¹TeO₂, R¹PO ou (R¹)₂PO ;
V est, de manière identique ou différente pour chaque occurrence, B, BR⁻, B(CR₂)₃, RB(CR₂)₃⁻, B(O)₃, RB(O)₃⁻, B(CR₂CR₂)₃, RB(CR₂CR₂)₃⁻, B(CR₂O)₃, RB(CR₂O)₃⁻, B(OCR₂)₃, RB(OCR₂)₃⁻, Al(O)₃, RAl(O)₃⁻, Al(OCR₂)₃, RAl(OCR₂)₃⁻, CR, CO⁻, CN(R¹)₂, RC(CR₂)₃, RC(O)₃, RC(CR₂CR₂)₃, RC(CR₂O)₃, RC(OCR₂)₃, RC(SiR₂)₃, RC(SiR₂CR₂)₃, RC(CR₂SiR₂)₃, RC(SiR₂SiR₂)₃, SiR, RSi(CR₂)₃, RSi(O)₃, RSi(CR₂CR₂)₃, RSi(OCR₂)₃, RSi(CR₂O)₃, RSi(SiR₂)₃, RSi(SiR₂CR₂)₃, RSi(CR₂SiR₂)₃, RSi(SiR₂SiR_{z})₃, N, NO, NR⁺, N(CR₂)₃, RN(CR₂)₃⁺, N(C=O)₃, N(CR₂CR₂)₃, RN(CR₂CR₂)⁺, P, PO, PS, PSe, PTe, P(O)₃, PO(O)₃, P(OCR₂)₃, PO(OCR₂)₃, P(CR₂)₃, PO(CR₂)₃, P(CR₂CR₂)₃, PO(CR₂CR₂)₃, As, AsO, AsS, AsSe, AsTe, As(O)₃, AsO(O)₃, As(OCR₂)₃, AsO(OCR₂)₃, As(CR₂)₃, AsO(CR₂)₃, As(CR₂CR₂)₃, AsO(CR₂CR₂)₃, Sb, SbO, SbS, SbSe, SbTe, Sb(O)₃, SbO(O)₃, Sb(OCR₂)₃, SbO(OCR₂)₃, Sb(CR₂)₃, SbO(CR₂)₃, Sb(CR₂CR₂)₃, SbO(CR₂CR₂)₃, Bi, BiO, BiS, BiSe, BiTe, Bi(O)₃, BiO(O)₃, Bi(OCR₂)₃, BiO(OCR₂)₃, Bi(CR₂)₃, BiO(CR₂)₃, Bi(CR₂CR₂)₃, BiO(CR₂CR₂)₃, S⁺, S(CR₂)₃⁺, S(CR₂CR₂)₃⁺, Se⁺, Se(CR₂)₃⁺, Se(CR₂CR₂)₃⁺, Te⁺, Te(CR₂)₃⁺, Te(CR₂CR₂)₃⁺ ou des analogues asymétriques en correspondance ; ou une unité de la formule (17) ou de la formule (18), 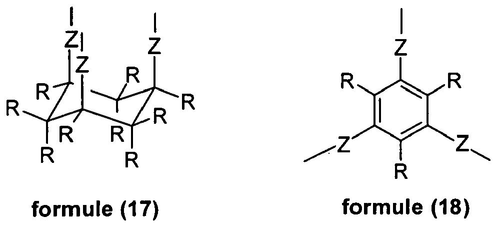
Z est, de manière identique ou différente pour chaque occurrence, un groupe divalent CR₂, NR, O, S, SiR₂, PR, CR₂-CR₂, CR₂-NR, CR₂-O, CR₂-S, CR₂-SiR₂ ou CR₂-PR ;
R est, de manière identique ou différente pour chaque occurrence, H, F, Cl, Br, I, NO₂, CN, un groupe alkyle ou alcoxy en chaîne droite, ramifié ou cyclique comportant de 1 à 20 atomes de C, où un ou plusieurs groupes CH₂ non adjacents peut/peuvent être remplacé(s) par -R¹C=CR¹-, -C≡C-, Si(R¹)₂, Ge(R¹)₂, Sn(R¹)₂, C=O, C=S, C=Se, C=NR¹, -O-, -S-, -NR¹- ou -CONR¹- et où un ou plusieurs atomes de H peut/peuvent être remplacé(s) par F, ou un groupe aryle, aryloxy ou hétéroaryle comportant de 1 à 14 atomes de C, lequel peut être substitué par un ou plusieurs radicaux non aromatiques R, ou un groupe diarylamino comportant de 6 à 20 atomes de C, lequel peut être substitué par un ou plusieurs radicaux non aromatiques R ; une pluralité de substituents R ici, à la fois sur le même cycle et également sur les deux cycles différents, peuvent en association à leur tour former un autre système de cycle, aliphatique, aromatique et/ou benzofusionné monocyclique ou polycyclique;
R¹ est, de manière identique ou différente pour chaque occurrence, H ou un radical hydrocarbone aliphatique ou aromatique comportant de 1 à 20 atomes de C ;
c est, de manière identique ou différente pour chaque occurrence, 0 ou 1.

10. Composant électronique organique selon la revendication 9, **caractérisé en ce que** M sur chaque occurrence, de manière identique ou différente, représente un ion de métal de transition présentant un numéro atomique supérieur à 38.

11. Composant électronique organique selon la revendication 9 et/ou 10, **caractérisé en ce que** Q sur chaque occurrence, de manière identique ou différente, représente O, S ou N.

12. Composant électronique organique selon une ou plusieurs des revendications 9 à 11, **caractérisé en ce que** E sur chaque occurrence, de manière identique ou différente, représente C ou N.

13. Composant électronique organique selon une ou plusieurs des revendications 9 à 12, **caractérisé en ce que** T sur chaque occurrence, de manière identique ou différente, représente N ou P.

14. Composant électronique organique selon une ou plusieurs des revendications 9 à 13, **caractérisé en ce que** X sur chaque occurrence, de manière identique ou différente, représente CR ou N.

15. Composant électronique organique selon une ou plusieurs des revendications 9 à 14, **caractérisé en ce que** V sur chaque occurrence, de manière identique ou différente, représente B, BR⁻, B(CR₂)₃, RB(CR₂)₃⁻ , B(O)₃, RB(O)₃⁻, B(CR₂CR₂)₃, B(OCR₂)₃, RB(OCR₂)₃⁻, CR, CNR¹₂, RC(CR₂)₃, RC(O)₃, RC(CR₂CR₂)₃, RC(CR₂O)₃, RC(OCR₂)₃, SiR, RSi(CR₂)₃, RSi(O)₃, RSi(CR₂CR₂)₃, RSi(OCR₂)₃, RSi(CR₂O)₃, N, NR⁺, N(CR₂)₃, RN(CR₂)₃⁺, N(C=O)₃, N(CR₂CR₂)₃, RN(CR₂CR₂)⁺, P, PO, P(O)₃, PO(O)₃, P(OCR₂)₃, PO(OCR₂)₃, S⁺, S(CR₂)₃⁺, S(CR₂CR₂)₃⁺ ou des analogues asymétriques en correspondance ou un groupe de la formule (17) ou de la formule (18).

16. Composant électronique organique selon une ou plusieurs des revendications 9 à 15, **caractérisé en ce que** Z sur chaque occurrence, de manière identique ou différente, représente un groupe divalent CR₂, NR, O, S, SiR₂ ou PR.

17. Composant électronique organique selon une ou plusieurs des revendications 9 à 16, **caractérisé en ce que** Y sur chaque occurrence, de manière identique ou différente, représente O, S ou NR¹.

18. Composant électronique organique selon une ou plusieurs des revendications 9 à 17, **caractérisé en ce que** R sur chaque occurrence, de manière identique ou différente, représente H, F, Cl, Br, I, CN, un groupe alkyle ou alcoxy en chaîne droite, ramifié ou cyclique comportant de 1 à 6 atomes de C ou un groupe aryle, aryloxy ou hétéroaryle comportant de 3 à 8 atomes de C, lequel peut être substitué par un ou plusieurs radicaux non aromatiques R, ou un groupe diarylamino comportant de 8 à 12 atomes de C, lequel peut être substitué par un ou plusieurs radicaux non aromatiques R ; deux substituents R ou plus ici, à la fois sur le même cycle et également sur les deux cycles différents, peuvent en association à leur tour former un autre système de cycle aliphatique, aromatique et/ou benzo-fusionné monocyclique ou polycyclique.

19. Composant électronique organique selon une ou plusieurs des revendications 9 à 18, **caractérisé en ce que** c sur chaque occurrence est égal à 0.

20. Composant électronique organique selon une ou plusieurs des revendications 1 à 19, **caractérisé en ce que** les ligands partiels L2 sont des ligands bidentés-chélatants qui comportent deux groupes de donneur D1 et D2, où les atomes de donneur sont choisis parmi les groupes principaux 5 et 6 ou représentent des groupes isonitrile, mais par ailleurs ne comportent pas de liaisons directes métal-carbone ; les groupes de donneur D1 et D2 ici ne peuvent pas tous deux représenter des systèmes cycliques qui sont tous deux liés au métal.

21. Composant électronique organique selon la revendication 20, **caractérisé en ce que** les atomes de donneur de groupes de donneur D1 et D2 sont azote, phosphore, oxygène ou soufre.

22. Composant électronique organique selon la revendication 21, **caractérisé en ce que** les groupes de donneur D1 et D2 sont des hétérocycles azote aromatiques, des amines aliphatiques, des amines cycliques aliphatiques, des nitriles, des amides, des imides, des imines, des alkylarylphosphines alkyle, aryle ou mixtes, des halogénures alkylarylphosphine alkyle, aryle ou mixtes, des phosphites alkyle, aryle ou alkyle-aryle mixtes, des phosphaaromatiques, des alcools, des alcoolates, des éthers à chaîne ouverte ou cycliques, des groupes carbonyle, des groupes oxyde de phosphine, des groupes de sulfoxyde, des carboxylates, des phénols, des phénolates, des oximes, des hydroxamates, des β-cétocétonates, des β-cétoesters, des β-diesters, des thiols et des thiolates aliphatiques ou aromatiques, des thioéthers à chaîne ouverte ou cycliques, des groupes thiophène, thiocarbonyle, des sulfures de phosphine ou des thiocarboxylates, dont chacun peut être substitué par des groupes R ou non substitué.

23. Composant électronique organique selon la revendication 22, **caractérisé en ce que** les ligands partiels L2 sont des β-cétocétonates, des β-cétoesters, des β-diesters, des pyridylcarboxylates, des acides α-amino, des iminoacétoacétonates, des hydroxamates, des diphosphines, des pyridylphosphines, des α-phosphinocarboxylates, des éthers glycol, des alcoolates d'éther, des diamines, des imines, des diimines, des carboxylates dérivés à partir d'acides amino-carboxyliques, des salicyliminates, des dialcoolates, des dithiolates, dont chacun est substitué par R ou non substitué.

24. Complexes métalliques de la formule (1), 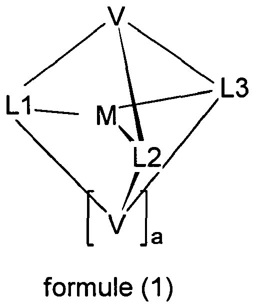 contenant au moins un métal M, coordonné sur un ligand polypodal L de la formule (2), 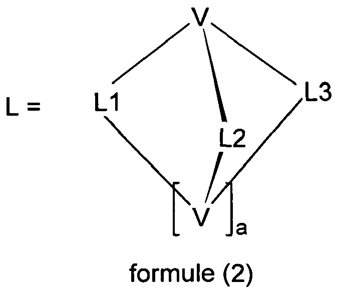 où V est une unité de pontage, contenant de 1 à 80 atomes issus des troisième, quatrième, cinquième et/ou sixième groupes principaux, laquelle lie de façon covalente les trois ligands partiels L1, L2 et L3 les uns aux autres, et où l'indice a est égal à 0 ou 1, où, dans le cas de a = 0, l'unité de pontage V est omise ;
le ligand partiel L1 ici est conforme à la formule (3), 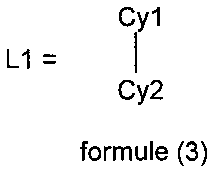 où Cy1 et Cy2 sont des groupes cycliques substitués ou non substitués dont chacun contient au moins un atome de donneur ou un atome de C dans le cycle ou selon une liaison exocyclique via laquelle le groupe cyclique est lié au métal ; les groupes Cy1 et Cy2 sont liés l'un à l'autre via une liaison covalente ou un bord commun et peuvent de façon additionnelle être reliés l'un à l'autre via des substituents et ainsi former un système de cycle polycyclique, aliphatique ou aromatique;
le ligand partiel L2 est un ligand de donneur, contenant un ou plusieurs atomes de donneur et de 2 à 40 atomes de C, étant entendu que le ligand partiel L2 n'est pas élaboré à partir de deux cycles ou de deux cycles partiels qui sont tous deux liés au métal ;
le ligand partiel L3 est identique au ligand partiel L1 ou au ligand partiel L2 ou en est différent,
**caractérisés en ce que** le ligand partiel L2 est un ligand bidenté-chélatant comportant deux atomes de donneur, et **en ce qu'**en outre soit l'indice a = 0, soit Cy1 n'est pas égal à Cy2, et l'un des deux cycles est lié au métal via une liaison métal-carbone et l'autre est lié au métal via un atome de donneur autre que le carbone.

25. Complexes métalliques selon la revendication 24, **caractérisés en ce que** le ligand L présente une structure de la formule (4) : 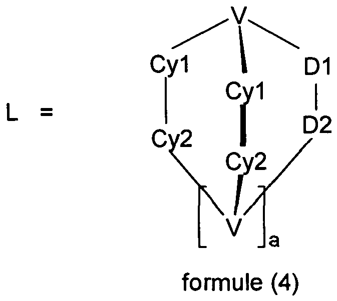 où les symboles D1 et D2, dans chaque cas de manière identique ou différente, représentent des groupes de donneur, chacun contenant un atome de donneur ; les autres symboles et indices utilisés présentent les significations mentionnées selon la revendication 24.

26. Procédé pour la préparation de complexes selon la revendication 24 ou 25 par réaction du ligand de la formule (2) ou de précurseurs de ce ligand avec des alcoolates métalliques de la formule (19), avec des cétocétonates métalliques de la formule (20) ou avec des halogénures métalliques de la formule (21), 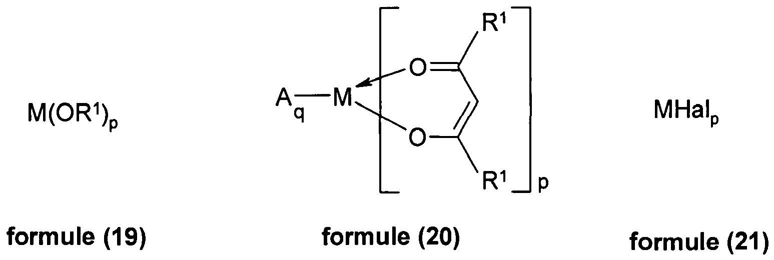 où ce qui suit s'applique aux symboles et indices :
M est, sur chaque occurrence, de manière identique ou différente, un ion de métal de transition ;
Hal est, sur chaque occurrence, de manière identique ou différente, F, Cl, Br où I ;
A est, sur chaque occurrence, de manière identique ou différente, un ligand neutre ou monoanionique, monodenté ou bidenté ;
p est, sur chaque occurrence, de manière identique ou différente, 1, 2, 3, 4 ou 5, où p dans les formules (19) et (21) indique la valence du métal M ;
q est, sur chaque occurrence, de manière identique ou différente, 0, 1, 2, 3 ou 4 ;
le composé de la formule (20) ici peut également être chargé et peut également contenir un contre-ion ; les autres symboles présentent la même signification que décrit sous la revendication 9.

27. Procédé selon la revendication 26, **caractérisé en ce que** la réaction est activée thermiquement, photochimiquement ou par rayonnement micro-ondes.

28. Procédé selon la revendication 26 et/ou 27, **caractérisé en ce que** le ligand de la formule (2) est amené à réagir avec des composés métalliques des formules (19), (20) et (21) :

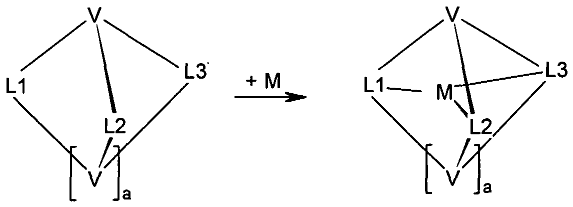

29. Procédé selon la revendication 26 et/ou 27, **caractérisé en ce qu'**un précurseur polypodal du cryptand est utilisé au niveau de l'étape de constitution de complexe, et la seconde unité de pontage V est introduite au niveau d'une seconde étape de synthèse : 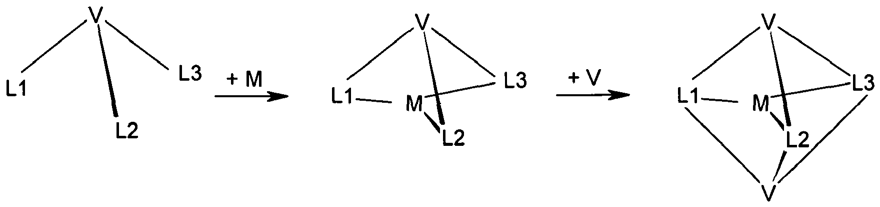 ou **en ce qu'**un précurseur simple du ligand est utilisé, et toutes les unités de pontage V sont formées au niveau d'une étape ultérieure : 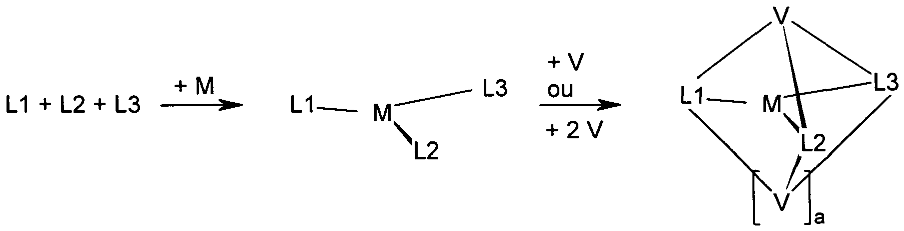 ou **en ce qu'**un précurseur simple ou macrocyclique du ligand est utilisé, et le troisième ligand partiel est introduit et relié aux unités de pontage V :

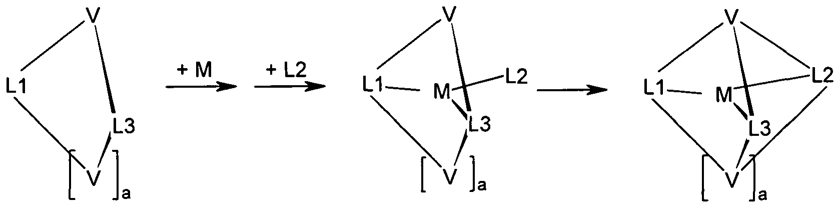

30. Polymères ou dendrimères conjugués, partiellement conjugués et non conjugués comprenant un ou plusieurs complexes de la formule qui suit (1), où une ou plusieurs liaisons sont présentes depuis les complexes jusqu'au polymère ou dendrimère, 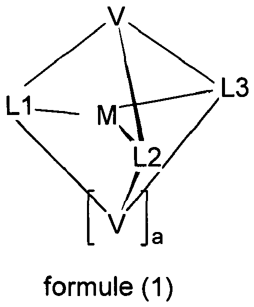 contenant au moins un métal M, coordonné sur un ligand polypodal L de la formule (2), 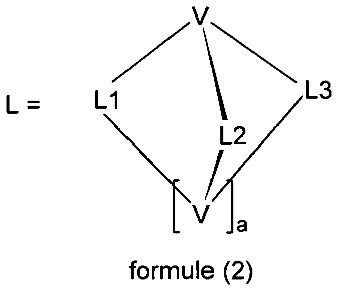 où V est une unité de pontage, contenant de 1 à 80 atomes issus des troisième, quatrième, cinquième et/ou sixième groupes principaux, laquelle lie de manière covalente les trois ligands partiels L1, L2 et L3 les uns aux autres, et où l'indice a est égal à 0 ou 1, où, dans le cas de a = 0, l'unité de pontage V est omise ;
le ligand partiel L1 est ici conforme à la formule (3), 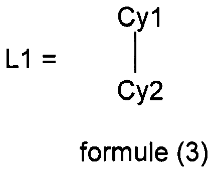 où Cy1 et Cy2 sont des groupes cycliques substitués ou non substitués dont chacun contient au moins un atome de donneur ou un atome de C dans le cycle ou selon une liaison exocyclique via laquelle le groupe cyclique est lié au métal ; les groupes Cy1 et Cy2 sont liés l'un à l'autre via une liaison covalente ou un bord commun et peuvent de façon additionnelle être reliés l'un à l'autre via des substituents et ainsi former un système de cycle polycyclique, aliphatique ou aromatique ;
le ligand partiel L2 est un ligand de donneur, contenant un ou plusieurs atomes de donneur et de 2 à 40 atomes de C, étant entendu que le ligand partiel L2 n'est pas élaboré à partir de deux cycles ou de deux cycles partiels qui sont tous deux liés au métal ;
le ligand partiel L3 est identique au ligand partiel L1 ou au ligand partiel L2 ou en est différent.

31. Utilisation de complexes selon une ou plusieurs des revendications 24, 25 ou 30 dans des composants électroniques organiques.
